# EUROPEAN PATENT APPLICATION

(11) **EP 4 167 300 A1**
(43) Date of publication of application: **19.04.2023**
(21) Application number: 20941464.8
(22) Date of filing: 10.12.2020
(51) Int. Cl.: H01L 31/072, H01L 31/0224, H01L 31/18

(54) **BACK CONTACT SOLAR CELL AND PRODUCTION METHOD, AND BACK CONTACT BATTERY ASSEMBLY**

(30) Priority: 15.06.2020 CN 202010544465; 15.06.2020 CN 202021106709 U; 15.06.2020 CN 202021108338 U; 15.06.2020 CN 202021101871 U
(71) Applicant: Longi Green Energy Technology Co., Ltd., Xi'an, Shaanxi 710100 (CN)
(72) Inventor: WU, Zhao, Shaanxi 710100 (CN); XU, Chen, Shaanxi 710100 (CN); LI, Zifeng, Shaanxi 710100 (CN)
(74) Representative: von Bülow & Tamada
(86) International application number: PCT/CN2020/135400
(87) International publication number: WO 2021/253751

(57) **Abstract**

A back-contacting solar cell and a producing method, and a back-contacting cell assembly, which relates to the technical field of photovoltaics. The back-contacting solar cell includes: a silicon substrate (1), wherein a shadow face of the silicon substrate (1) is delimited into a first region and a second region (2), and the second region (2) is doped to form a second-charge-carrier collecting end; a metal-chalcogen-compound layer (4), wherein the metal-chalcogen-compound layer (4) is deposited within at least the first region of the silicon substrate (1), and a region of the metal-chalcogen-compound layer (4) that corresponds to the first region forms a first-charge-carrier collecting end; a first electrode (5), wherein the first electrode (5) is correspondingly provided on the first-charge-carrier collecting end; and a second electrode (6), wherein the second electrode (6) is correspondingly provided within a region that corresponds to the second region (2). The collection and transferring of the first charge carrier are realized by using the first-charge-carrier collecting end. The metal-chalcogen-compound layer (4) has a good adjustability in the structure and the performance, a good thermal stability, and a wide window of process selection, and can realize a lower transverse-conduction capacity and a higher longitudinal-conduction capacity.

## Description

The present application claims the priorities of the Chinese patent application filed on June 15th, 2020 before the Chinese Patent Office with the application number of 202010544465.9 and the title of "BACK CONTACT SOLAR CELL AND PRODUCTION METHOD, AND BACK CONTACT BATTERY ASSEMBLY", the Chinese patent application filed on June 15th, 2020 before the Chinese Patent Office with the application number of 202021106709.7 and the title of "IBC CELL AND IBC ASSEMBLY", the Chinese patent application filed on June 15th, 2020 before the Chinese Patent Office with the application number of 202021108338.6 and the title of "FULL-BACK-ELECTRODE SOLAR CELL AND FULL- BACK-ELECTRODE CELL ASSEMBLY", and the Chinese patent application filed on June 15th, 2020 before the Chinese Patent Office with the application number of 202021101871.X and the title of "SOLAR CELL AND PHOTOVOLTAIC ASSEMBLY", which are incorporated herein in its entirety by reference.

### TECHNICAL FIELD

The present disclosure relates to the technical field of photovoltaics, and particularly relates to a back-contacting solar cell and a producing method, and a back-contacting cell assembly.

### BACKGROUND

Back-contacting solar cells, because the light facing face is totally not blocked by the electrodes, can realize a high photoelectric conversion efficiency, and thus have extensive applications.

Currently, in back-contacting solar cells, it is usually required to fabricate, at the shadow face of the silicon substrate, regions of different types of electric conduction that are accurately aligned and are electrically isolated from each other.

However, the fabrication of the regions of different types of electric conduction that are accurately aligned and are electrically isolated from each other results in a poor process stability.

### SUMMARY

The present disclosure provides a back-contacting solar cell and a producing method, and a back-contacting cell assembly, which aims at solving the problem of a poor process stability.

According to the first aspect of the present disclosure, there is provided a back-contacting solar cell, wherein the back-contacting solar cell comprises:
a silicon substrate, wherein a shadow face of the silicon substrate is delimited into a first region and a second region;
a metal-chalcogen-compound layer, wherein the metal-chalcogen-compound layer is deposited within at least the first region of the silicon substrate, and a region of the metal-chalcogen-compound layer that corresponds to the first region forms a first-charge-carrier collecting end;
a first electrode, wherein the first electrode is correspondingly provided on the first-charge-carrier collecting end; and
a second electrode, wherein the second electrode is correspondingly provided within a region that corresponds to the second region.

The conduction-band energy level of the metal-chalcogen-compound layer at the interface closer to the first region is close to the conducting energy level of the first charge carrier within the first region, which can serve to absorb the first charge carrier and reject the second charge carrier, and accordingly the region of the metal-chalcogen-compound layer that corresponds to the first region forms the first-charge-carrier collecting end, which realizes the collection and transferring of the first charge carrier by using the first-charge-carrier collecting end. The metal-chalcogen-compound layer has a good adjustability in the structure and the performance, a good thermal stability, and a wide window of process selection, and can realize a lower transverse-conduction capacity and a higher longitudinal-conduction capacity.

Optionally, the silicon substrate within the second region is doped to form a second-charge-carrier collecting end;
the metal-chalcogen-compound layer is deposited on the whole shadow face of the silicon substrate;
a region of the metal-chalcogen-compound layer that corresponds to the second region forms a second-charge-carrier transferring region; and
the second electrode is correspondingly provided within the second-charge-carrier transferring region.

In the embodiment of the present disclosure, the second-charge-carrier collecting end is formed by doping the second region of the shadow face of the silicon substrate, and can absorb the second charge carrier and reject the first charge carrier, to serve for the selectivity of the second charge carrier, whereby, at the second-charge-carrier collecting end, the second charge carrier has a higher density, and the first charge carrier has a lower density. Moreover, the charge-carrier conducting energy level of the continuous whole-layer metal-chalcogen-compound layer at the interface closer to the first region is close to the conducting energy level of the first charge carrier within the first region, which can serve to absorb the first charge carrier and reject the second charge carrier, and accordingly the region of the metal-chalcogen-compound layer that corresponds to the first region forms the first-charge-carrier collecting end, which realizes the collection and transferring of the first charge carrier by using the first-charge-carrier collecting end. At the second-charge-carrier collecting end, because the second charge carrier has a higher density, and the first charge carrier has a lower density, the charge-carrier conducting energy level of the metal-chalcogen-compound layer is close to the conducting energy level of the second charge carrier corresponding to the second region. Therefore, the second charge carrier of the second-charge-carrier collecting end can directly enter the region of the metal-chalcogen-compound layer that corresponds to the second region, and, accordingly, the region of the metal-chalcogen-compound layer that corresponds to the second region serves as the second-charge-carrier transferring region, which realizes the collection and transferring of the second charge carrier. In other words, in the metal-chalcogen-compound layer, the region that corresponds to the first region realizes the collection and transferring of the first charge carrier, and the region that corresponds to the second region realizes the collection and transferring of the second charge carrier. In other words, the different regions of the metal-chalcogen-compound layer individually realize the transferring of the second charge carrier and the collection of the first charge carrier. In addition, the metal-chalcogen-compound layer has a lower transverse-transferring capacity, and all of the different types of charge carriers, after collected, are longitudinally transferred to enter the corresponding electrodes, and are not communicated with each other due to transverse transferring to cause electric leakage or short circuiting. Therefore, no additional alignment and electric isolation are required, which results in a simple process, reduces recombination, and increases the photoelectric conversion efficiency. In addition, the second-charge-carrier collecting end, the first-charge-carrier collecting end and the metal-chalcogen-compound layer do not contact each other to generate a reverse PN junction.

Optionally, the silicon substrate within the second region is doped to form a second-charge-carrier collecting end; the metal-chalcogen-compound layer is deposited merely within the first region; and the second electrode is correspondingly provided on the second-charge-carrier collecting end;
or
the metal-chalcogen-compound layer is deposited on the whole shadow face of the silicon substrate; at least a part of the metal-chalcogen-compound layer that corresponds to the second region has an opening that electrically segments the metal-chalcogen-compound layer; a second-charge-carrier selecting layer is formed at the part of the metal-chalcogen-compound layer that corresponds to the second region, and the second-charge-carrier selecting layer fills the opening; and the second electrode is correspondingly provided on the second-charge-carrier selecting layer.

In the embodiment of the present disclosure, the second-charge-carrier collecting end is formed by doping the second region of the shadow face of the silicon substrate, and can absorb the second charge carrier and reject the first charge carrier, to serve for the selectivity of the second charge carrier, whereby, at the second-charge-carrier collecting end, the second charge carrier has a higher density, and the first charge carrier has a lower density. The metal-chalcogen-compound layer, as the first-charge-carrier collecting end, is deposited merely within the first region of the shadow face of the silicon substrate, and its charge-carrier conducting energy level is close to the conducting energy level of the first charge carrier within the first region, which can serve to absorb the first charge carrier and reject the second charge carrier, which realizes the collection and transferring of the first charge carrier by using the first-charge-carrier collecting end. The first electrode is correspondingly provided on the first-charge-carrier collecting end, and the second electrode is correspondingly provided on the second-charge-carrier collecting end. In other words, the second region of the shadow face of the doped silicon substrate realizes the collection and transferring of the second charge carrier, and the metal-chalcogen-compound layer deposited merely within the first region of the shadow face of the silicon substrate realizes the collection and transferring of the first charge carrier. The different substances located at the different positions individually realize the collection and transferring of the different charge carriers, and no additional alignment and electric isolation are required, which results in a simple process, reduces the area of the no-collection region, and increases the photoelectric conversion efficiency. In addition, the charge-carrier conducting energy levels of the collecting or conducting materials of the charge-carrier collecting regions are close to the transferring energy levels of the corresponding charge carriers in the silicon material, and the transferring interface has no or a low barrier potential, which reduces the longitudinal contact resistance. Alternatively, on the basis that the second-charge-carrier collecting end absorbs the second charge carrier and rejects the first charge carrier, to serve for the selectivity of the second charge carrier, the charge-carrier conducting energy level of the continuous whole-layer metal-chalcogen-compound layer at the interface closer to the first region is close to the conducting energy level of the first charge carrier within the first region, which can serve to absorb the first charge carrier and reject the second charge carrier, and accordingly the part of the metal-chalcogen-compound layer that corresponds the first region forms the first-charge-carrier collecting end, which realizes the collection and transferring of the first charge carrier by using the first-charge-carrier collecting end. Moreover, at least the part of the continuous whole-layer metal-chalcogen-compound layer that corresponds to the second region has an opening that electrically segments the metal-chalcogen-compound layer, the opening is filled with the second-charge-carrier selecting layer, and the second electrode is provided on the second-charge-carrier selecting layer. That is equivalent to that the second charge carrier is transferred merely by the second-charge-carrier selecting layer, and the first charge carrier is transferred mainly by the part of the metal-chalcogen-compound layer that has no opening. That realizes that the different substances individually transfer the different charge carriers, and no additional alignment and electric isolation are required, which results in a simple process, reduces the area of the no-collection region, and increases the photoelectric conversion efficiency. In addition, the first charge carrier and the second charge carrier are transferred by the different substances, and the second-charge-carrier selecting layer more facilitates the transferring of the second charge carrier, which can reduce the longitudinal contact resistance. In addition, the second-charge-carrier collecting end, the first-charge-carrier collecting end and the metal-chalcogen-compound layer do not contact each other to generate a reverse PN junction.

Optionally, the silicon substrate within the second region is doped to form a second-charge-carrier collecting end;
the metal-chalcogen-compound layer is deposited on the whole shadow face of the silicon substrate;
the metal-chalcogen-compound layer has a blocking component that electrically segments the metal-chalcogen-compound layer into a second-charge-carrier transferring region and the first-charge-carrier collecting end;
the second-charge-carrier transferring region corresponds to the second region; and
the second electrode is correspondingly provided within the second-charge-carrier transferring region.

In the embodiment of the present disclosure, the second-charge-carrier collecting end is formed by doping the second region of the shadow face of the silicon substrate, and can absorb the second charge carrier and reject the first charge carrier, to serve for the selectivity of the second charge carrier, whereby, at the second-charge-carrier collecting end, the second charge carrier has a higher density, and the first charge carrier has a lower density. The blocking component electrically segments the metal-chalcogen-compound layer into the second-charge-carrier transferring region and the first-charge-carrier collecting end, and the charge-carrier conducting energy level of the first-charge-carrier collecting end at the interface closer to the first region is close to the conducting energy level of the first charge carrier within the first region, which can serve to absorb the first charge carrier and reject the second charge carrier. At the second-charge-carrier collecting end, because the second charge carrier has a higher density, and the first charge carrier has a lower density, the charge-carrier conducting energy level of the second-charge-carrier transferring region is close to the conducting energy level of the second charge carrier corresponding to the second region. Therefore, the second charge carrier of the second-charge-carrier collecting end can directly enter the second-charge-carrier transferring region, which realizes the collection and transferring of the second charge carrier. In addition, by segmenting the second-charge-carrier transferring region and the first-charge-carrier collecting end by using the blocking component, the transverse-transferring capacity of the whole metal-chalcogen-compound layer can be very low, which can increase the longitudinal-conduction capacity of the metal-chalcogen-compound layer and prevent transverse electric leakage, and in turn can reduce the longitudinal series resistance to a large extent. Furthermore, by segmenting the second-charge-carrier transferring region and the first-charge-carrier collecting end by using the blocking component, all of the different types of charge carriers, after collected, are longitudinally transferred to enter the corresponding electrodes, and are not communicated with each other due to transverse transferring to cause electric leakage or short circuiting. Therefore, no precise doping alignment is required, which results in a simple process, reduces recombination, and increases the photoelectric conversion efficiency. In addition, the second-charge-carrier collecting end, the first-charge-carrier collecting end and the metal-chalcogen-compound layer do not contact each other to generate a reverse PN junction.

Optionally, the back-contacting solar cell further comprises: a second-charge-carrier selectively-collecting layer;
the second-charge-carrier selectively-collecting layer is deposited within the second region of the silicon substrate;
the metal-chalcogen-compound layer is deposited within the first region and on a shadow face of the second-charge-carrier selectively-collecting layer;
the part of the metal-chalcogen-compound layer that corresponds to the second-charge-carrier selectively-collecting layer forms a second-charge-carrier transferring region; and
the second electrode is correspondingly provided within the second-charge-carrier transferring region.

In the embodiment of the present disclosure, the second-charge-carrier selectively-collecting layer is deposited within the second region of the shadow face of the silicon substrate, which does not require high-temperature diffusion, and has a low process temperature. The charge-carrier conducting energy level of the second-charge-carrier selectively-collecting layer is close to the conducting energy level of the second charge carrier of the silicon substrate, and can absorb the second charge carrier and reject the first charge carrier, to serve for the selectivity of the second charge carrier. The charge-carrier conducting energy level of the metal-chalcogen-compound layer at the interface of the region outside the second-charge-carrier selectively-collecting layer is close to the conducting energy level of the first charge carrier within the first region of the shadow face of the silicon substrate, which can serve to absorb the first charge carrier and reject the second charge carrier, and accordingly the region of the metal-chalcogen-compound layer that is outside the second-charge-carrier transferring region forms the first-charge-carrier collecting end, which realizes the collection and transferring of the first charge carrier by using the first-charge-carrier collecting end. In other words, the region of the metal-chalcogen-compound layer that corresponds to the second-charge-carrier selectively-collecting layer realizes the transferring of the second charge carrier, and the region of the metal-chalcogen-compound layer that is outside it realizes the collection and transferring of the first charge carrier. In other words, the different regions of the metal-chalcogen-compound layer individually realize the transferring of the second charge carrier and the collection of the first charge carrier. In addition, in the metal-chalcogen-compound layer, the interface between the second-charge-carrier transferring region and the first-charge-carrier collecting end has a high-resistance defect, which can realize insulation, in order not to have electric leakage or short circuiting. Therefore, no additional alignment and electric isolation are required, which results in a simple process, reduces recombination, and increases the photoelectric conversion efficiency. The second-charge-carrier selectively-collecting layer employs a deposited selective-contacting structure, and the metal-chalcogen-compound layer also employs a deposited selective-contacting structure, which has the advantage of a low body-region recombination, and is not limited by the limit of auger recombination. In addition, the second-charge-carrier selectively-collecting layer and the first-charge-carrier collecting end do not contact each other to generate a reverse PN junction.

According to the second aspect of the present disclosure, there is provided a method for producing a back-contacting solar cell, wherein the method comprises:
providing a silicon substrate, wherein a shadow face of the silicon substrate is delimited into a first region and a second region;
depositing within at least the first region of the silicon substrate to obtain a metal-chalcogen-compound layer, wherein a region of the metal-chalcogen-compound layer that corresponds to the first region forms a first-charge-carrier collecting end;
correspondingly providing a first electrode on the first-charge-carrier collecting end; and
correspondingly providing a second electrode within a region that corresponds to the second region.

According to the third aspect of the present disclosure, there is provided a back-contacting cell assembly, wherein the back-contacting cell assembly comprises: the back-contacting solar cell according to any one of the above-described embodiments.

The above description is merely a summary of the technical solutions of the present disclosure. In order to more clearly know the elements of the present disclosure to enable the implementation according to the contents of the description, and in order to make the above and other purposes, features and advantages of the present disclosure more apparent and understandable, the particular embodiments of the present disclosure are provided below.

### BRIEF DESCRIPTION OF THE DRAWINGS

In order to more clearly illustrate the technical solutions of the embodiments of the present disclosure or the prior art, the figures that are required to describe the embodiments or the prior art will be briefly described below. Apparently, the figures that are described below are embodiments of the present disclosure, and a person skilled in the art can obtain other figures according to these figures without paying creative work.

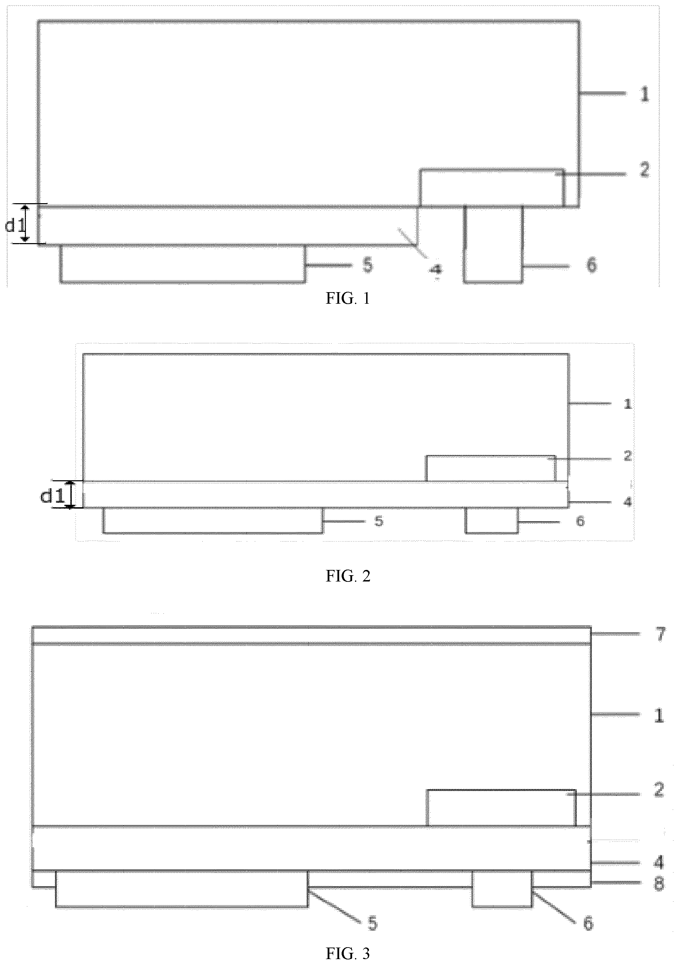

FIGS. 1-23 show schematic structural diagrams of the first type to the twenty-third type of back-contacting solar cell according to the embodiments of the present disclosure.

### Description of the reference numbers:

1-silicon substrate, 2-second region, 3-tunneling isolating layer, 4-metal-chalcogen-compound layer, 22-second-charge-carrier selecting layer, 23-second-charge-carrier selectively-collecting layer, 5-first electrode, 6-second electrode, 52-first transparent electrically conductive thin film, 53-first work-function regulating layer, 63-second transparent electrically conductive thin film, 62-second work-function regulating layer, 64-third work-function regulating layer, 65-third transparent electrically conductive thin film, 66-fourth work-function regulating layer, 67-fourth transparent electrically conductive thin film, 68-fifth work-function regulating layer, 69-fifth transparent electrically conductive thin film, 7-front-face antireflective-thin-film layer, 8-back-face passivating film or shadow-face antireflective film, and 9-blocking component.

### DETAILED DESCRIPTION

In order to make the objects, the technical solutions and the advantages of the embodiments of the present disclosure clearer, the technical solutions of the embodiments of the present disclosure will be clearly and completely described below with reference to the drawings of the embodiments of the present disclosure. Apparently, the described embodiments are merely certain embodiments of the present disclosure, rather than all of the embodiments. All of the other embodiments that a person skilled in the art obtains on the basis of the embodiments of the present disclosure without paying creative work fall within the protection scope of the present disclosure.

In an embodiment of the present disclosure, referring to FIG. 1, FIG. 1 shows a schematic structural diagram of the first type of back-contacting solar cell according to an embodiment of the present disclosure. The back-contacting solar cell comprises: a silicon substrate 1, wherein the shadow face of the silicon substrate 1 is delimited into a first region and a second region 2. In FIG. 1, the region of the shadow face of the silicon substrate 1 other than the second region 2 is the first region.

A metal-chalcogen-compound layer 4 is deposited within at least the first region of the silicon substrate 1. It should be noted that whether the metal-chalcogen-compound layer 4 is deposited within the second region 2 of the silicon substrate 1 is not particularly limited. For example, in the back-contacting solar cell shown in FIG. 1, within the second region 2 of the silicon substrate 1 not metal-chalcogen-compound layer 4 is deposited.

The region of the metal-chalcogen-compound layer 4 that corresponds to the first region of the shadow face of the silicon substrate 1 forms a first-charge-carrier collecting end. The first-charge-carrier collecting end can realize the collection and transferring of the first charge carrier.

It can be understood that, in the back-contacting solar cell, there are merely two charge carriers. Therefore, the first charge carrier is selected from one of a majority carrier and a minority carrier, and the second charge carrier is the other of the majority carrier and the minority carrier. In other words, when the first charge carrier is a majority carrier, the second charge carrier is definitely a minority carrier, and when the second charge carrier is a majority carrier, the first charge carrier is definitely a minority carrier. It should be noted that, in the present disclosure, whether the majority carrier and the minority carrier are particularly electrons or holes is decided mainly by the doping type of the silicon substrate 1. If the doping type of the silicon substrate 1 is an N type, then in the back-contacting solar cell according to the present disclosure the majority carrier is electrons, and the minority carrier is holes. If the doping type of the silicon substrate 1 is a P type, then in the back-contacting solar cell according to the present disclosure the majority carrier is holes, and the minority carrier is electrons.

In the metal-chalcogen-compound layer 4 the first-charge-carrier collecting end is correspondingly provided with a first electrode 5, and the first electrode 5 is used to conduct a first charge carrier. A second electrode 6 is correspondingly provided within a region that corresponds to the second region 2, and the second electrode 6 is used to conduct a second charge carrier. It should be noted that an electrically insulating gap is required to be left between the first electrode 5 and the second electrode 6, wherein the electrically insulating gap is not smaller than the breakdown distance under the normal working voltage. The first electrode 5 and the second electrode 6 may be fabricated by printing, deposition and so on. The second electrode 6 and the first electrode 5 may be metal electrodes.

The conduction-band energy level of the metal-chalcogen-compound layer 4 at the interface closer to the first region is close to the conducting energy level of the first charge carrier within the first region, which can serve to absorb the first charge carrier and reject the second charge carrier, and accordingly the region of the metal-chalcogen-compound layer 4 that corresponds to the first region forms the first-charge-carrier collecting end, which realizes the collection and transferring of the first charge carrier by using the first-charge-carrier collecting end. The metal-chalcogen-compound layer 4 has a good adjustability in the structure and the performance, a good thermal stability, and a wide window of process selection, and can realize a lower transverse-conduction capacity and a higher longitudinal-conduction capacity.

Optionally, referring to FIG. 2, FIG. 2 shows a schematic structural diagram of the second type of back-contacting solar cell according to an embodiment of the present disclosure. The metal-chalcogen-compound layer 4 is deposited on the whole shadow face of the silicon substrate 1. That, as compared with other material layers deposited on the whole shadow face of the silicon substrate 1, has a good adjustability in the structure and the performance, can realize a lower transverse-conduction capacity and a higher longitudinal-conduction capacity, and has a good thermal stability, and a wide window of process selection.

In FIG. 2, the region of the metal-chalcogen-compound layer 4 that corresponds to the second region of the shadow face of the silicon substrate 1 forms a second-charge-carrier transferring region. The second-charge-carrier transferring region can realize the transferring of the second charge carrier. The second electrode 6 is correspondingly provided within the second-charge-carrier transferring region of the metal-chalcogen-compound layer 4, and the second electrode 6 is used to conduct a second charge carrier.

Optionally, the second region 2 is doped to form a second-charge-carrier collecting end. The second-charge-carrier collecting end can realize the collection and transferring of the second charge carrier. It should be noted that the doping types of the second region 2 and the second region itself of the silicon substrate 1 are the same or different, and if the doping types are the same, the doping elements may be the same or different, which is not particularly limited in the embodiments of the present disclosure.

Optionally, the area of the projection of the second-charge-carrier collecting end on the shadow face of the silicon substrate 1 accounts for 5% to 45% of the total area of the shadow face of the silicon substrate. That area proportion results in a good effect of the collection and transferring of the second charge carrier, and at the same time does not affect the collection and transferring of the first charge carrier.

Optionally, a top view of the second-charge-carrier collecting end may be a punctate pattern or a linear pattern. The punctate pattern is, for example, a circle or an ellipse. The linear pattern is, for example, a rectangle, a polygon and so on. A top view of the second-charge-carrier collecting end is a punctate pattern or a linear pattern, which results in a simple process to realize the doping of the second region.

Optionally, the doping concentration of the second-charge-carrier collecting end is greater than or equal to 10¹⁵ cm⁻³, and greater than the doping concentration of the silicon substrate 1 within the first region, which results in a better effect of the collection and transferring of the second charge carrier.

Referring to FIG. 2, the case in which the silicon substrate 1 is an N-type silicon substrate, the second charge carrier is electrons and the first charge carrier is holes will be taken as an example below for the description. The second-charge-carrier collecting end is of a doped structure, which can cause that the energy band of the N-type silicon substrate bends downwardly within the second region 2, to attract electrons and reject holes, to serve for the selective collection of electrons. The region of the metal-chalcogen-compound layer 4 that corresponds to the first region forms a first-charge-carrier collecting end, and the first-charge-carrier collecting end is the hole collecting end. The metal chalcogen compound within the first region (i.e., the first-charge-carrier collecting end) behaves as a hole selectively-contacting material. The conduction-band energy level of that material is close to the valence-band energy level of the N-type silicon substrate, and the material can have interface defects of negative charges or negative fixing, which can cause that the energy band at the interface bends upwardly, to form an interface P-type layer, to serve to attract holes and reject electrons. At the first-charge-carrier collecting end, a material having a high selectivity causes a strong interface band bending, and the first-charge-carrier collecting end has a low conduction-band-bottom energy level, whereby the holes can enter the hole-selective material by the tunneling-recombination mechanism, to realize the collection and transferring of the holes. Within the second-charge-carrier transferring region, because the region has a higher electron density, and a lower hole density, the conduction-band-bottom energy level of the region is low, and is close to the conduction-band-bottom energy level of the second-charge-carrier collecting end. Therefore, the electrons can directly enter the second-charge-carrier transferring region in the metal-chalcogen-compound layer that corresponds to the second-charge-carrier collecting end, thereby realizing the transferring of the electrons.

It should be noted that the conduction-band energy level and the valence-band energy level according to the present disclosure generally refer to the energy levels of the material itself, i.e., the energy levels when the material exists solely, and do not refer to the actual energy levels in the cell.

In FIG. 2, the metal-chalcogen-compound layer 4 can realize both of the collection of the holes and the transferring of the electrons. In addition, the material may have a low transverse-electric-conduction capacity by regulating the crystallization performance, the crystalline phase and the doping element. Regarding the holes at the first-charge-carrier collecting end and the electrons at the second-charge-carrier transferring region, all of the different types of charge carriers, after collected, are longitudinally transferred to enter the corresponding electrodes, and are not communicated with each other due to transverse transferring to cause electric leakage or short circuiting. Therefore, the different types of charge-carrier collecting ends do not require additional electric isolation, and do not contact each other to generate a reverse PN junction.

In FIG. 2, the second-charge-carrier collecting end employs a locally doped selective-contacting structure, and the metal-chalcogen-compound layer 4 employs a deposited selective-contacting structure, which, as compared with the traditional full-diffusion back-contacting structure, has the advantage of a low body-region recombination at the minority-carrier collecting region, and has fewer diffusion steps and a simpler process. As compared with the structure using amorphous silicon as the back contacting, the metal-chalcogen-compound layer 4 has a higher selectivity, and a higher thermal stability, and the process of the material deposition has lower requirements on the equipment, and a higher safety. The metal-chalcogen-compound layer 4 can fully cover the back face of the cell, to further simplify the process.

By forming the first-charge-carrier collecting end by using the region of the metal-chalcogen-compound layer 4 that corresponds to the first region, as compared with amorphous-silicon materials, the first-charge-carrier collecting end has higher selectivity and longitudinal-transferring capacity, and a higher capacity of the collection and longitudinal transferring of the first charge carrier. In addition, at the second-charge-carrier collecting end, cooperating with the locally doped structure, the second charge carrier is transferred via the band edge of the chalcogen-compound material, which does not involve the trans-energy-level tunneling mechanism, and therefore the transferring of the second charge carrier has little obstruction, which can realize a lower contact resistance.

Optionally, the metal-chalcogen-compound layer 4 may be one or more layers. Referring to FIGS. 1 and 2, the thickness d1 of the metal-chalcogen-compound layer 4 may be 1-600nm. More preferably, d1 is 2-100nm. Such a thickness range is beneficial to the transferring and collection of the second charge carrier and the first charge carrier.

Other cases, for example, in which the silicon substrate 1 is a P-type silicon substrate and the second charge carrier is holes, may be comprehended by referring to the above.

Optionally, if the silicon substrate is an N-type silicon substrate and the second charge carrier is a majority carrier, or if the silicon substrate is a P-type silicon substrate and the second charge carrier is a minority carrier, the material of the metal-chalcogen-compound layer 4 is selected from at least one of first materials, wherein the first materials are N-type metal oxides of a work function greater than or equal to 5eV, or P-type metal oxides of a work function less than or equal to 6eV. Regarding the above two cases, the second-charge-carrier transferring region in the metal-chalcogen-compound layer 4 of such materials is beneficial to the transferring of the second charge carrier, and the first-charge-carrier collecting end in the metal-chalcogen-compound layer 4 of such materials is beneficial to the transferring and collection of the first charge carrier.

Particularly, if the silicon substrate is an N-type silicon substrate and the second charge carrier is electrons, or if the silicon substrate is a P-type silicon substrate and the second charge carrier is electrons, the material of the metal-chalcogen-compound layer 4 is selected from at least one of the above-described first materials.

Optionally, the first materials are selected from at least one of molybdenum oxide, tungsten oxide, vanadium oxide, niobium oxide, nickel oxide, mercury-doped niobium oxide (for example, Hg₂Nb₂O₇) and mercury-doped tantalum oxide (for example, Hg₂Ta₂O₇). If the silicon substrate is an N-type silicon substrate and the second charge carrier is electrons, or if the silicon substrate is a P-type silicon substrate and the second charge carrier is electrons, the first-charge-carrier collecting end in the metal-chalcogen-compound layer 4 of such materials is beneficial to the transferring and collection of the first charge carrier, and the second-charge-carrier transferring region in the metal-chalcogen-compound layer 4 of such materials is beneficial to the transferring of the second charge carrier.

Optionally, if the silicon substrate is a P-type silicon substrate and the second charge carrier is a majority carrier, or if the silicon substrate is an N-type silicon substrate and the second charge carrier is a minority carrier, the material of the metal-chalcogen-compound layer is selected from at least one of second materials, wherein the second materials are metal chalcogen compounds of a work function greater than or equal to 3eV. The second-charge-carrier transferring region in the metal-chalcogen-compound layer 4 of such materials is beneficial to the transferring of the second charge carrier, and the first-charge-carrier collecting end in the metal-chalcogen-compound layer 4 of such materials is beneficial to the transferring and collection of the first charge carrier.

Particularly, if the silicon substrate is a P-type silicon substrate and the second charge carrier is holes, or if the silicon substrate is an N-type silicon substrate and the second charge carrier is holes, the material of the metal-chalcogen-compound layer 4 is selected from at least one of the above-described second materials.

Optionally, the second materials are selected from at least one of zinc oxide, tin oxide, titanium oxide, cupric oxide, thallium oxide, cadmium sulfide, molybdenum sulfide, zinc sulfide, molybdenum selenide, copper selenide, niobium-doped cupric oxide (for example, CuNb₃O₈), cadmium germanium oxide (for example, Ce_{0.8}Gd_{0.2}O₂), iridium zinc oxide (for example, ZnIr₂O₄) and cobalt calcium oxide (for example Ca₃Co₄O₉). If the silicon substrate is a P-type silicon substrate and the second charge carrier is holes, or if the silicon substrate is an N-type silicon substrate and the second charge carrier is holes, the second-charge-carrier transferring region in the metal-chalcogen-compound layer 4 of such materials is beneficial to the transferring of the second charge carrier, and the first-charge-carrier collecting end in the metal-chalcogen-compound layer 4 of such materials is beneficial to the transferring and collection of the first charge carrier.

Optionally, the metal chalcogen compounds contain a doping element, and the doping element is selected from at least one of a halogen element, a transition-metal element, an alkali-metal element, a rare-earth element, a group-III element, a group-IV element and a group-V element. The second-charge-carrier transferring region in the metal-chalcogen-compound layer 4 of such materials is beneficial to the transferring of the second charge carrier, and the first-charge-carrier collecting end in the metal-chalcogen-compound layer 4 of such materials is beneficial to the transferring and collection of the first charge carrier.

Optionally, the transverse-conduction capacity of the metal-chalcogen-compound layer 4 is less than or equal to 1.0×10⁻³ S/cm, and the transverse resistance is greater than or equal to 1.0×10³ Ω/cm, whereby it can block transverse currents well. The transverse-electric-conduction capacity may be reduced by regulating the material structure, for example, the crystallization performance and the crystalline phase, or by processes such as doping.

Optionally, in FIG. 2, if the silicon substrate is a P-type silicon substrate and the second charge carrier is a majority carrier, or if the silicon substrate is an N-type silicon substrate and the second charge carrier is a minority carrier, the region of the metal-chalcogen-compound layer 4 that corresponds to the first region forms a first-charge-carrier collecting end, to collect and transfer electrons as the first charge carrier, and the region of the metal-chalcogen-compound layer 4 that corresponds to the second region forms the second-charge-carrier transferring region, to transfer holes as the second charge carrier. The fixed-positive-charge density at the interface or the interior of the metal-chalcogen-compound layer 4 is greater than or equal to 10¹¹ cm⁻², and/or the acceptor-defect density at the interface or the interior of the metal-chalcogen-compound layer 4 is greater than or equal to 10¹¹ cm⁻², and/or the limited-charge density at the interface or the interior of the metal-chalcogen-compound layer 4 is greater than or equal to 10¹¹ cm⁻². The second-charge-carrier transferring region in the metal-chalcogen-compound layer 4 of such materials is beneficial to the transferring of the second charge carrier, and the first-charge-carrier collecting end in the metal-chalcogen-compound layer 4 of such materials is beneficial to the transferring and collection of the first charge carrier.

Optionally, in FIG. 2, if the silicon substrate is an N-type silicon substrate and the second charge carrier is a majority carrier, or if the silicon substrate is a P-type silicon substrate and the second charge carrier is a minority carrier, the region of the metal-chalcogen-compound layer 4 that corresponds to the first region forms a first-charge-carrier collecting end, to collect and transfer holes as the first charge carrier, and the region of the metal-chalcogen-compound layer 4 that corresponds to the second region forms the second-charge-carrier transferring region, to transfer electrons as the second charge carrier. The fixed-negative-charge density at the interface or the interior of the metal-chalcogen-compound layer 4 is greater than or equal to 10¹² cm⁻², and/or the donor-defect density at the interface or the interior of the metal-chalcogen-compound layer 4 is greater than or equal to 10¹² cm⁻², and/or the limited-charge density at the interface or the interior of the metal-chalcogen-compound layer 4 is greater than or equal to 10¹² cm⁻². The second-charge-carrier transferring region in the metal-chalcogen-compound layer 4 of such materials is beneficial to the transferring of the second charge carrier, and the first-charge-carrier collecting end in the metal-chalcogen-compound layer 4 of such materials is beneficial to the transferring and collection of the first charge carrier.

Optionally, the average light transmittance of the metal-chalcogen-compound layer 4 within a visible-light wave band is greater than or equal to 70%. Accordingly, the metal-chalcogen-compound layer 4 blocks visible lights to a low extent, which facilitates to increase the photoelectric conversion efficiency.

Optionally, the shadow face of the silicon substrate 1 is of a planar structure or a light trapping structure, and the light facing face of the metal-chalcogen-compound layer 4 matches with the shadow face of the silicon substrate 1. Additionally or alternatively, the light facing face of the silicon substrate 1 is of a planar structure or a light trapping structure. The light trapping structure can increase the optical path, to increase the photoelectric conversion efficiency. The light trapping structure may be a suede, an inverted pyramid, a nano-sized light trapping structure and so on.

Optionally, the light facing face of the silicon substrate may also be provided with at least one of a passivation layer, a front-face field-effect layer, a front-face antireflective-thin-film layer, a scattering-structure layer and a light-focusing-structure layer. Additionally or alternatively, at the shadow face of the metal-chalcogen-compound layer, a back-face passivating film is provided within a region outside the second electrode and the first electrode, to realize passivation, optical improvement and so on.

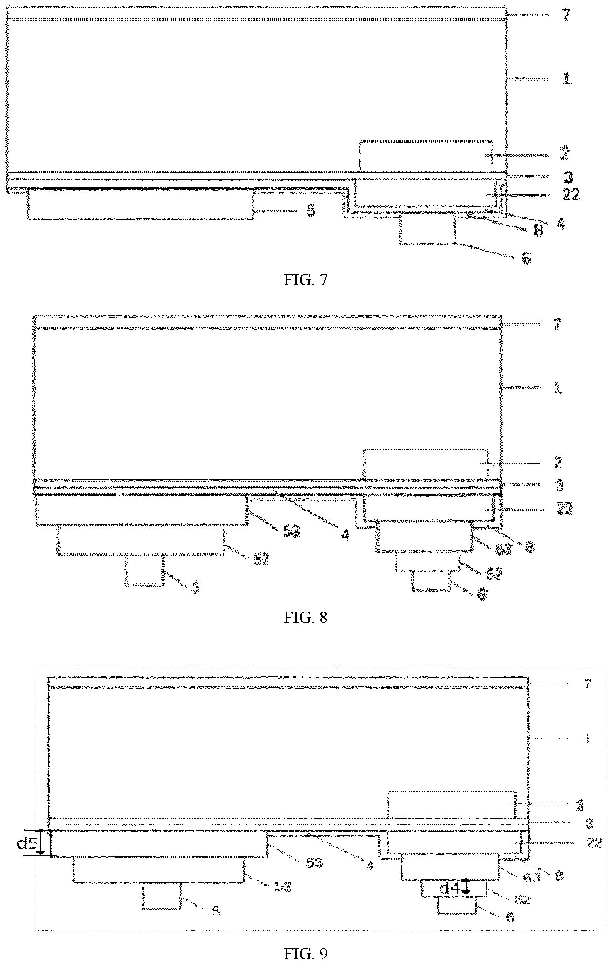

For example, referring to FIG. 3, FIG. 3 shows a schematic structural diagram of the third type of back-contacting solar cell according to an embodiment of the present disclosure. In FIG. 3, 7 may be a front-face antireflective-thin-film layer, and 8 may be a back-face passivating film.

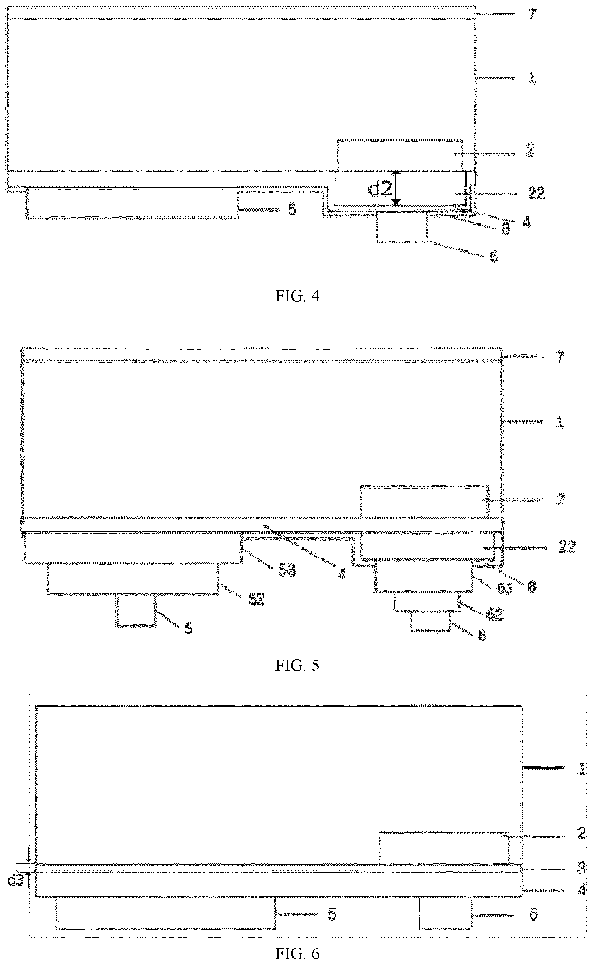

Optionally, referring to FIG. 4, FIG. 4 shows a schematic structural diagram of the fourth type of back-contacting solar cell according to an embodiment of the present disclosure. A second-charge-carrier selecting layer 22 is deposited at the shadow face of the second region 2, and the second-charge-carrier selecting layer 22 can further improve the capacity of the second region 2 of transferring the second charge carrier. The projection of the second region 2 and the projection of the second-charge-carrier selecting layer 22 at least partially coincide, to facilitate the processing. For example, as shown in FIG. 4, the projection of the second region 2 and the projection of the second-charge-carrier selecting layer 22 have a high degree of coinciding.

The second-charge-carrier selecting layer 22 is located at the shadow face or the light facing face of the metal-chalcogen-compound layer 4. For example, referring to FIG. 4, the second-charge-carrier selecting layer 22 is located at the light facing face of the metal-chalcogen-compound layer 4. As another example, referring to FIG. 5, FIG. 5 shows a schematic structural diagram of the fifth type of back-contacting solar cell according to an embodiment of the present disclosure. The second-charge-carrier selecting layer 22 is located at the shadow face of the metal-chalcogen-compound layer 4.

Optionally, referring to FIG. 4 or 5, the second-charge-carrier selecting layer 22 is one or more layers. The thickness d2 of the second-charge-carrier selecting layer 22 is 1-500nm. More preferably, d2 is 2-60nm. The second-charge-carrier selecting layer 22 of such a thickness is beneficial to the transferring of the second charge carrier.

Optionally, the area of the projection of the second-charge-carrier selecting layer 22 on the shadow face of the silicon substrate 1 accounts for 5% to 45% of the total area of the shadow face of the silicon substrate 1. That area proportion results in a good effect of the transferring of the second charge carrier, and at the same time does not affect the collection and transferring of the first charge carrier. It should be noted that the areas of the second-charge-carrier selecting layer 22 and the second region 2 are equal or unequal, which is not particularly limited in the embodiments of the present disclosure.

Optionally, if the silicon substrate is an N-type silicon substrate and the second charge carrier is a majority carrier, or if the silicon substrate is a P-type silicon substrate and the second charge carrier is a minority carrier, the material of the second-charge-carrier selecting layer is selected from a crystalline-silicon material of a work function greater than or equal to 3eV, an amorphous-silicon material of a work function greater than or equal to 3eV, and at least one of second materials, wherein the second materials are metal chalcogen compounds of a work function greater than or equal to 3eV. The second-charge-carrier selecting layer of such materials has a good effect of the collection and transferring of the second charge carrier.

Optionally, if the silicon substrate is a P-type silicon substrate and the second charge carrier is a majority carrier, or if the silicon substrate is an N-type silicon substrate and the second charge carrier is a minority carrier, the material of the second-charge-carrier selecting layer may be selected from at least one of first materials, wherein the first materials are N-type metal chalcogen compounds of a work function greater than or equal to 5eV, or P-type metal chalcogen compounds of a work function less than or equal to 6eV. The second-charge-carrier selecting layer of such materials has a good effect of the collection and transferring of the second charge carrier.

The particular selection of the second materials and the first materials may refer to the relevant description in the above embodiments, to obtain the same or similar advantageous effects, which, in order to avoid replication, is not discussed herein further.

Optionally, a tunneling isolating layer is provided between the shadow face of the silicon substrate and the metal-chalcogen-compound layer. The tunneling isolating layer may be one or more layers, and the thickness of the tunneling isolating layer is 0.1nm-5nm. The tunneling isolating layer serves well for surface passivation, which can reduce the recombination of the electric currents at the interface.

For example, referring to FIG. 6, FIG. 6 shows a schematic structural diagram of the sixth type of back-contacting solar cell according to an embodiment of the present disclosure. On the basis of FIG. 2, a tunneling isolating layer 3 is provided between the shadow face of the silicon substrate 1 and the metal-chalcogen-compound layer 4, and the thickness d3 of the tunneling isolating layer 3 is 0.1nm-5nm. Referring to FIG. 7, FIG. 7 shows a schematic structural diagram of the seventh type of back-contacting solar cell according to an embodiment of the present disclosure. On the basis of FIG. 4, the tunneling isolating layer 3 is located between the shadow face of the silicon substrate 1 and the light facing face of the metal-chalcogen-compound layer 4 and the light facing face of the second-charge-carrier selecting layer 22. As another example, referring to FIG. 8, FIG. 8 shows a schematic structural diagram of the eighth type of back-contacting solar cell according to an embodiment of the present disclosure. The tunneling isolating layer 3 is located between the shadow face of the silicon substrate 1 and the light facing face of the metal-chalcogen-compound layer 4 and the light facing face of the second-charge-carrier selecting layer 22.

Optionally, the material of the tunneling isolating layer is selected from at least one of an oxide of silicon, a nitride of silicon, an oxynitride of silicon and a halide of silicon. The tunneling isolating layer of such materials has a better effect of chemical surface passivation. The tunneling isolating layer may be separately formed, for example, by in-situ reaction processes such as wet thermal oxidation and dry thermal oxidation, or by deposition such as chemical vapor deposition and physical vapor deposition. Alternatively, the tunneling isolating layer may be integrated with the metal-chalcogen-compound layer; for example, the interface silicon-oxide layer that is formed in the growth of the metal chalcogen compound or in the post-annealing is used as the tunneling isolating layer. It should be noted that, if the tunneling isolating layer is a material not containing silicon, it may comprise a chemical transition layer between it and the silicon material.

Optionally, the material of the tunneling isolating layer may be a dielectric material, and the dielectric constant of the tunneling isolating layer is greater than 2. The dielectric material refers to a material that may be polarized into an insulating material. The material of the tunneling isolating layer may be a dielectric material, and have a dielectric constant greater than 2, which does not only have a good effect of chemical surface passivation, but also has a good effect of field passivation, which can block transverse electric conduction well.

Optionally, the breakdown voltage of the tunneling isolating layer is greater than or equal to 3MV/cm, which results in a good effect of surface passivation, and blocks transverse electric conduction well.

Optionally, the material of the tunneling isolating layer is selected from at least one of silicon oxide (for example, SiOₓ), silicon nitride (for example, SiNₓ), silicon fluoride (for example, SiF₄), silicon fluoride oxide (for example, SiOF), silicon carbon oxide (for example, SiOC), aluminium oxide (for example, Al₂O₃), aluminum fluoride (for example, AlFₓ) and aluminum oxynitride (for example, AlON). The tunneling isolating layer of such materials has a good effect of surface passivation, and blocks transverse electric conduction well. It should be noted that a person skilled in the art may select a suitable value of the x in the chemical formula according to practical situations.

Optionally, a second transparent electrically conductive thin film and/or a second work-function regulating layer are provided between the second-charge-carrier collecting end and the second electrode. In other words, the second transparent electrically conductive thin film, or the second work-function regulating layer, or both of them, may be provided between the second-charge-carrier collecting end and the second electrode. Both of the second transparent electrically conductive thin film and/or the second work-function regulating layer are located within a projection region of the second-charge-carrier collecting end. It should be noted that, if both of them are provided, the second transparent electrically conductive thin film may be located on the shadow face or the light facing face of the second work-function regulating layer. The projection of the second electrode may be located within the projection of the second transparent electrically conductive thin film and/or the second work-function regulating layer.

Additionally or alternatively, a first transparent electrically conductive thin film and/or a first work-function regulating layer are provided between the first-charge-carrier collecting end and the first electrode. In other words, the first transparent electrically conductive thin film, or the first work-function regulating layer, or both of them, may be provided between the first-charge-carrier collecting end and the first electrode. Both of the first transparent electrically conductive thin film and/or the first work-function regulating layer are located within a projection region of the first-charge-carrier collecting end. It should be noted that, if both of them are provided, the first transparent electrically conductive thin film may be located on the shadow face or the light facing face of the first work-function regulating layer. The projection of the first electrode may be located within the projection of the first transparent electrically conductive thin film and/or the first work-function regulating layer.

The first transparent electrically conductive thin film and the second transparent electrically conductive thin film can serve to assist the transferring of the charge carriers, and are light-transmitting, which can further increase the photoelectric conversion efficiency. The first work-function regulating layer and the second work-function regulating layer serve to reduce the contact resistance.

FIG. 9 shows a schematic structural diagram of the ninth type of back-contacting solar cell according to an embodiment of the present disclosure. For example, referring to FIG. 5, 8 or 9, a second transparent electrically conductive thin film 63 and a second work-function regulating layer 62 are provided between the second-charge-carrier collecting end and the second electrode 6. The second transparent electrically conductive thin film 63 is located at the light facing face of the second work-function regulating layer 62. A first transparent electrically conductive thin film 52 and a first work-function regulating layer 53 are provided between the first-charge-carrier collecting end and the first electrode 5. The first transparent electrically conductive thin film 52 is located at the shadow face of the first work-function regulating layer 53.

Optionally, referring to FIG. 9, both of the thickness d4 of the second work-function regulating layer 62 and the thickness d5 of the first work-function regulating layer 53 are 0.1-5nm. Such a thickness range can reduce the contact resistance to a larger extent.

Optionally, the second transparent electrically conductive thin film is formed by compounding or mixing a transparent electrically conductive material and a work-function regulating material. Additionally or alternatively, the first transparent electrically conductive thin film is formed by compounding or mixing a transparent electrically conductive material and a work-function regulating material. In other words, the first transparent electrically conductive thin film and the second transparent electrically conductive thin film cannot only serve to assist the transferring of the charge carriers, but also are light-transmitting, which can further increase the photoelectric conversion efficiency, and can reduce the contact resistance or the longitudinal resistance.

Optionally, if the second transparent electrically conductive thin film is provided between the second-charge-carrier collecting end and the second electrode, the second electrode is provided at the shadow face of the second transparent electrically conductive thin film in the form of grid lines, to sufficiently utilize the light transmission of the back face, which can further increase the photoelectric conversion efficiency.

Additionally or alternatively, if the first transparent electrically conductive thin film is provided between the first-charge-carrier collecting end and the first electrode, the first electrode is provided at the shadow face of the first transparent electrically conductive thin film in the form of grid lines, to sufficiently utilize the light transmission of the back face, which can further increase the photoelectric conversion efficiency.

Optionally, each of materials of the first transparent electrically conductive thin film and the second transparent electrically conductive thin film is independently selected from at least one of zinc oxide, aluminum-doped zinc oxide, tin oxide, indium-doped tin oxide and indium-gallium-doped tin oxide. The first transparent electrically conductive thin film and the second transparent electrically conductive thin film of such materials have a better performance of transferring the charge carriers, which can further increase the photoelectric conversion efficiency.

Optionally, both of the work functions of the first work-function regulating layer and the second work-function regulating layer are 1eV-5.5eV, which can further reduce the contact resistance.

Optionally, all of the materials of the first work-function regulating layer and the second work-function regulating layer and the work-function regulating materials of the first transparent electrically conductive thin film and/or the second transparent electrically conductive thin film may be independently selected from at least one of an alkali metal, a transition metal, an alkali-metal halide and a transition-metal halide, which can further reduce the contact resistance.

Optionally, all of the materials of the first work-function regulating layer and the second work-function regulating layer and the work-function regulating materials of the first transparent electrically conductive thin film and/or the second transparent electrically conductive thin film may be independently selected from Ca, Mg, Ba, LiFₓ, KFₓ, MgFₓ, BaClₓ and so on. Here, a person skilled in the art may select a suitable value of the x in the chemical formula according to practical situations.

Optionally, the work functions of the work-function regulating materials of the first transparent electrically conductive thin film and/or the second transparent electrically conductive thin film are 1eV-5.5eV, which can further reduce the contact resistance.

Optionally, referring to FIG. 1, the second region 2 is doped to form a second-charge-carrier collecting end. The second-charge-carrier collecting end can realize the collection and transferring of the second charge carrier. It should be noted that the doping types of the second region 2 and the second region itself of the silicon substrate 1 are the same, but the doping elements may be the same or different, which is not particularly limited in the embodiments of the present disclosure.

The doping concentration and so on of the second-charge-carrier collecting end may refer to the above relevant description, which, in order to avoid replication, is not discussed herein further.

Referring to FIG. 1, the metal-chalcogen-compound layer 4, as the first-charge-carrier collecting end, is deposited merely within the first region of the shadow face of the silicon substrate 1. The first-charge-carrier collecting end can realize the collection and transferring of the first charge carrier.

Referring to FIG. 1, the second electrode 6 is correspondingly provided on the second-charge-carrier collecting end, and the second electrode 6 is used to conduct a second charge carrier. The first electrode 5 is correspondingly provided on the first-charge-carrier collecting end, and the first electrode 5 is used to conduct a first charge carrier. It should be noted that an electrically insulating gap is required to be left between the second electrode 6 and the first electrode 5, wherein the electrically insulating gap is not smaller than the breakdown distance under the normal working voltage. The second electrode 6 and the first electrode 5 may be fabricated by printing, deposition and so on. The first electrode 5 and the second electrode 6 may be metal electrodes.

In FIG. 1, the second region 2 of the shadow face of the doped silicon substrate 1 realizes the collection and transferring of the second charge carrier, and the metal-chalcogen-compound layer 4 deposited merely within the first region of the shadow face of the silicon substrate 1 realizes the collection and transferring of the first charge carrier. The different substances located at the different positions individually realize the collection and transferring of the different charge carriers, and no additional alignment and electric isolation are required, which results in a simple process, reduces the area of the no-collection region, and increases the photoelectric conversion efficiency. In addition, the second-charge-carrier collecting end is directly connected to the second electrode 6, and the first-charge-carrier collecting end is directly connected to the first electrode 5. The charge-carrier conducting energy levels of them are close, and no contacting barrier potential or merely little contacting barrier potential exists therebetween, which reduces the longitudinal contact resistance. In addition, the second-charge-carrier collecting end, the first-charge-carrier collecting end and the metal-chalcogen-compound layer 4 do not contact each other to generate a reverse PN junction. Additionally, the metal-chalcogen-compound layer 4 has a good adjustability in the structure and the performance, can realize a lower transverse-conduction capacity and a higher longitudinal-conduction capacity, and has a good thermal stability, and a wide window of process selection.

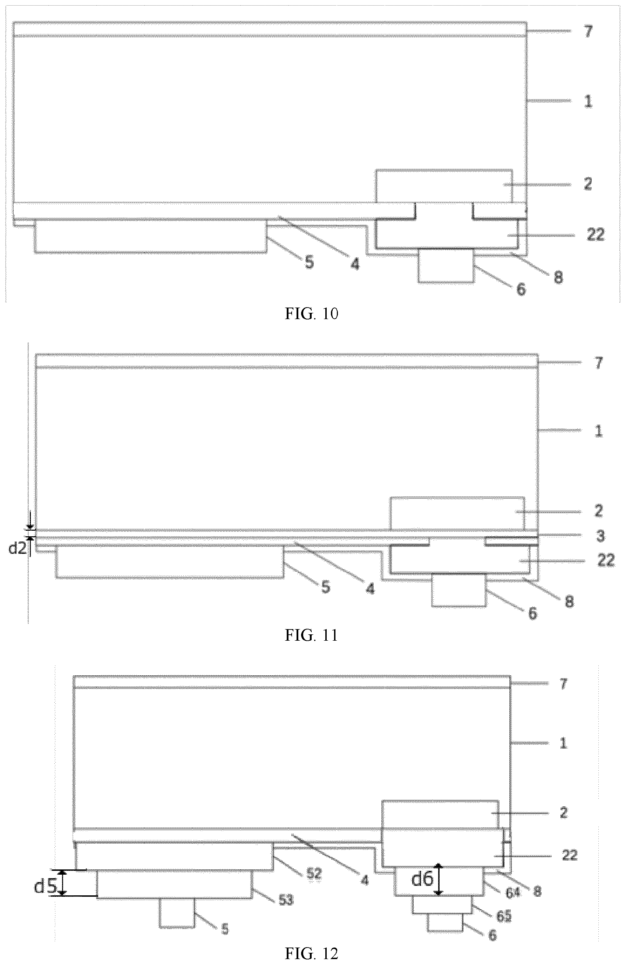

Alternatively, referring to FIG. 10, FIG. 10 shows a schematic structural diagram of the tenth type of back-contacting solar cell according to an embodiment of the present disclosure. The back-contacting solar cell may also comprise: a silicon substrate 1, wherein the shadow face of the silicon substrate 1 is delimited into a first region and a second region 2. The second region 2 of the silicon substrate 1 is doped to form the second-charge-carrier collecting end, and this part may refer to the above relevant description, which, in order to avoid replication, is not discussed herein further. Referring to FIG. 10, the metal-chalcogen-compound layer 4 is deposited on the whole shadow face of the silicon substrate 1, which, as compared with other material layers deposited on the whole shadow face of the silicon substrate 1, has a good adjustability in the structure and the performance, can realize a lower transverse-conduction capacity and a higher longitudinal-conduction capacity, and has a good thermal stability, and a wide window of process selection.

Referring to FIG. 10, the part of the metal-chalcogen-compound layer 4 that corresponds to the first region of the shadow face of the silicon substrate 1 forms a first-charge-carrier collecting end. The first-charge-carrier collecting end can realize the collection and transferring of the first charge carrier. The first electrode 5 is correspondingly provided on the first-charge-carrier collecting end, to cause a low longitudinal contact resistance.

Referring to FIG. 10, at least the part of the metal-chalcogen-compound layer 4 that corresponds to the second region of the shadow face of the silicon substrate 1 has an opening that electrically segments the metal-chalcogen-compound layer 4. The opening may completely cut the metal-chalcogen-compound layer 4, or partially cut the metal-chalcogen-compound layer 4. The opening is filled with a second-charge-carrier selecting layer 22, and the second-charge-carrier selecting layer 22 is used to transfer the second charge carrier. The second electrode 6 is correspondingly provided on the second-charge-carrier selecting layer 22. Accordingly, the second charge carrier passes through the second-charge-carrier selecting layer 22 and is collected by the second electrode 6. It should be noted that the opening region is substantially equal to the second region, and may be larger than or smaller than the second region. A peripheral region of the second-charge-carrier selecting layer 22 may be larger than the opening region. The opening may completely or partially segment the metal-chalcogen-compound layer 4.

The second electrode 6 and the first electrode 5 may also refer to the above relevant description, which, in order to avoid replication, is not discussed herein further.

Referring to FIG. 1 or 10, if the silicon substrate 1 is an N-type silicon substrate, if the first charge carrier is holes, the second charge carrier is electrons. The second-charge-carrier collecting end is the electron accumulating region. The second-charge-carrier collecting end is of a doped structure, which can cause that the energy band of the N-type silicon substrate bends downwardly within the second region 2, to attract electrons and reject holes, to serve for the selective collection of electrons. Referring to FIG. 1, the metal-chalcogen-compound layer 4 forms the first-charge-carrier collecting end, and the first-charge-carrier collecting end is the hole accumulating region. The first-charge-carrier collecting end behaves as a hole selectively-contacting material. The conduction-band energy level of that material is close to the valence-band energy level of the N-type silicon substrate, and the material can have interface defects of negative charges or negative fixing, which can cause that the energy band at the interface bends upwardly, to form an interface P-type layer, to serve to attract holes and reject electrons. Alternatively, referring to FIG. 10, the part of the metal-chalcogen-compound layer 4 that corresponds to the first region forms the first-charge-carrier collecting end, and the first-charge-carrier collecting end is the hole accumulating region. The part of the first-charge-carrier collecting end in the metal-chalcogen-compound layer that corresponds to the first region behaves as a hole selectively-contacting material. The conduction-band energy level of that material is close to the valence-band energy level of the N-type silicon substrate, and the material can have interface defects of negative charges or negative fixing, which can cause that the energy band at the interface bends upwardly, to form an interface P-type layer, to serve to attract holes and reject electrons. Referring to FIG. 10, regarding the second-charge-carrier selecting layer 22, because this part has a higher electron density, and a lower hole density, the conduction-band-bottom energy level of this part is low, and is close to the conduction-band-bottom energy level of the second-charge-carrier collecting end, which facilitates the transferring of the electrons.

It should be noted that the conduction-band energy level and the valence-band energy level described above generally refer to the energy levels of the material itself, i.e., the energy levels when the material exists solely, and do not refer to the actual energy levels in the cell.

In FIG. 1 or 10, the second-charge-carrier collecting end employs a locally doped selective-contacting structure, and the metal-chalcogen-compound layer 4 employs a deposited selective-contacting structure, which, as compared with the traditional full-diffusion back-contacting structure, has the advantage of a low body-region recombination at the minority-carrier collecting part, and has fewer diffusion steps and a simpler process. As compared with the structure using amorphous silicon as the back contacting, the metal-chalcogen-compound layer 4 has a higher selectivity, and a higher thermal stability, and the process of the material deposition has lower requirements on the equipment, and a higher safety.

By forming the first-charge-carrier collecting end by using the part of the metal-chalcogen-compound layer 4 that corresponds to the first region, as compared with amorphous-silicon materials, the first-charge-carrier collecting end has higher selectivity and longitudinal-transferring capacity, and a higher capacity of the collection and longitudinal transferring of the first charge carrier.

In FIG. 10, at least the part of the continuous whole-layer metal-chalcogen-compound layer 4 that corresponds to the second region 2 has an opening that electrically segments the metal-chalcogen-compound layer 4, the opening is filled with the second-charge-carrier selecting layer 22, and the second electrode 6 is provided on the second-charge-carrier selecting layer 22. That is equivalent to that the second charge carrier is transferred merely by the second-charge-carrier selecting layer 22, and the first charge carrier is transferred mainly by the part of the metal-chalcogen-compound layer 4 that has no opening. That realizes that the different substances individually transfer the different charge carriers, and no additional alignment and electric isolation are required, which results in a simple process, reduces the area of the no-collection region, and increases the photoelectric conversion efficiency. In addition, the first charge carrier and the second charge carrier are transferred by the different substances, and the second-charge-carrier selecting layer 22 more facilitates the transferring of the second charge carrier, and has a charge-carrier conducting energy level closer to that of the second region 2, whereby the contacting therebetween has no or a very low barrier potential, which can reduce the longitudinal contact resistance. In addition, the second-charge-carrier collecting end, the first-charge-carrier collecting end and the metal-chalcogen-compound layer 4 do not contact each other to generate a reverse PN junction. Additionally, the metal-chalcogen-compound layer 4 has a good adjustability in the structure and the performance, can realize a lower transverse-conduction capacity and a higher longitudinal-conduction capacity, and has a good thermal stability, and a wide window of process selection.

Optionally, the projection of the second region 2 and the projection of the second-charge-carrier selecting layer 22 at least partially coincide, to facilitate the processing. The second-charge-carrier selecting layer 22 is located at the shadow face or the light facing face of the metal-chalcogen-compound layer 4. For example, as shown in FIG. 10, the projection of the second region 2 and the projection of the second-charge-carrier selecting layer 22 have a high degree of coinciding. In FIG. 10, it may be considered that the second-charge-carrier selecting layer 22 is located at the shadow face of the metal-chalcogen-compound layer 4.

Optionally, the metal-chalcogen-compound layer 4 may be one or more layers. Referring to FIG. 1, the thickness d1 of the metal-chalcogen-compound layer 4 refers to the above relevant description.

Optionally, the area of the projection of the second-charge-carrier selecting layer 22 on the shadow face of the silicon substrate 1 accounts for 5% to 45% of the total area of the shadow face of the silicon substrate 1. That area proportion results in a good effect of the transferring of the second charge carrier, and at the same time does not affect the collection and transferring of the first charge carrier. It should be noted that the areas of the second-charge-carrier selecting layer 22 and the second region 2 are equal or unequal, which is not particularly limited.

Referring to FIG. 11, FIG. 11 shows a schematic structural diagram of the eleventh type of back-contacting solar cell according to an embodiment of the present disclosure. On the basis of FIG. 10, a tunneling isolating layer 3 is provided between the shadow face of the silicon substrate 1 and the metal-chalcogen-compound layer 4, and the thickness d2 of the tunneling isolating layer 3 is 0.1nm-5nm. The opening, when completely segmenting the metal-chalcogen-compound layer 4, may completely or partially segment the tunneling isolating layer 3. The material and so on of the tunneling isolating layer 3 refer to the above relevant description.

Optionally, if the second electrode is correspondingly provided on the second-charge-carrier selecting layer, a third transparent electrically conductive thin film and/or a third work-function regulating layer are provided between the second-charge-carrier selecting layer and the second electrode. In other words, the third transparent electrically conductive thin film, or the third work-function regulating layer, or both of them, may be provided between the second-charge-carrier selecting layer and the second electrode. Both of the third transparent electrically conductive thin film and/or the third work-function regulating layer are located within a projection part of the second-charge-carrier selecting layer. It should be noted that, if both of them are provided, the third transparent electrically conductive thin film may be located on the shadow face or the light facing face of the third work-function regulating layer.

The third transparent electrically conductive thin film can serve to assist the transferring of the charge carriers, and is light-transmitting, which can further increase the photoelectric conversion efficiency. The third work-function regulating layer can serve to reduce the contact resistance.

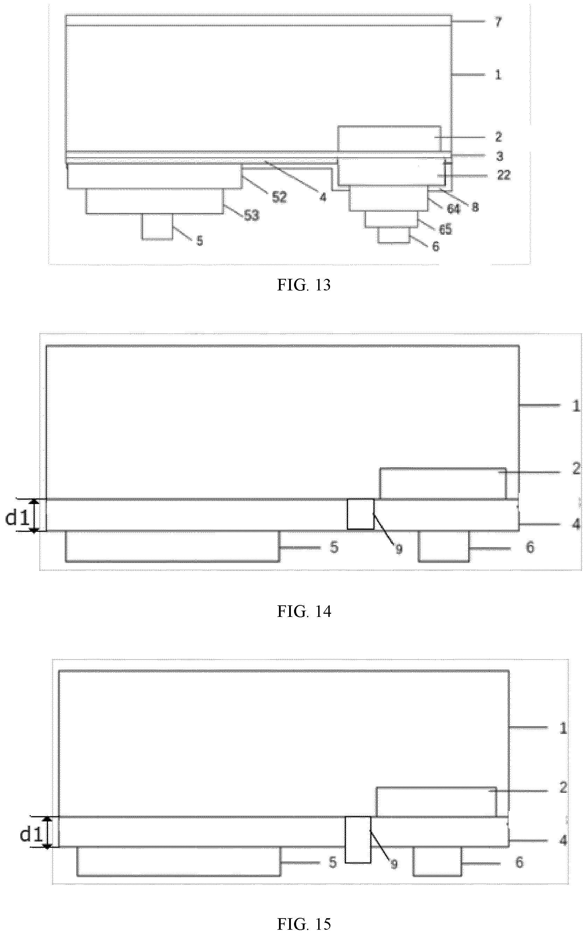

FIG. 12 shows a schematic structural diagram of the twelfth type of back-contacting solar cell according to an embodiment of the present disclosure. As another example, referring to FIG. 13, FIG. 13 shows a schematic structural diagram of the thirteenth type of back-contacting solar cell according to an embodiment of the present disclosure. FIGS. 12 and 13 differ in that, in FIG. 13, a tunneling isolating layer 3 is provided between the shadow face of the silicon substrate 1 and the metal-chalcogen-compound layer 4. Referring to FIG. 12 or 13, a first transparent electrically conductive thin film 52 and a first work-function regulating layer 53 are provided between the first-charge-carrier collecting end and the first electrode 5. The first transparent electrically conductive thin film 52 is located at the light facing face of the first work-function regulating layer 53. Referring to FIG. 12 or 13, a third transparent electrically conductive thin film 65 and a third work-function regulating layer 64 are provided between the second-charge-carrier selecting layer 22 and the second electrode 6. The third transparent electrically conductive thin film 65 is located at the shadow face of the third work-function regulating layer 64.

Optionally, referring to FIG. 12, the thickness d6 of the third work-function regulating layer 64 is 0.1-2nm. Such a thickness range can reduce the contact resistance to a larger extent. Such a thickness range can reduce the contact resistance to a larger extent.

Optionally, the third transparent electrically conductive thin film is formed by compounding or mixing a transparent electrically conductive material and a work-function regulating material. The third transparent electrically conductive thin film cannot only serve to assist the transferring of the charge carriers, but also is light-transmitting, which can further increase the photoelectric conversion efficiency, and can reduce the contact resistance or the longitudinal resistance.

Optionally, if the third transparent electrically conductive thin film is provided between the second-charge-carrier selecting layer and the second electrode, the second electrode is provided at the shadow face of the third transparent electrically conductive thin film in the form of grid lines, to sufficiently utilize the light transmission of the shadow face, which can further increase the photoelectric conversion efficiency.

Optionally, the material of the third transparent electrically conductive thin film is selected from at least one of zinc oxide, aluminum-doped zinc oxide, tin oxide, indium-doped tin oxide and indium-gallium-doped tin oxide. The third transparent electrically conductive thin film of such materials has a better performance of transferring the charge carriers, which can further increase the photoelectric conversion efficiency.

Optionally, the work function of the third work-function regulating layer is 1eV-5.5eV, which can further reduce the contact resistance.

Optionally, each of the material of the third work-function regulating layer and/or the work-function regulating material of the third transparent electrically conductive thin film may be independently selected from at least one of an alkali metal, a transition metal, an alkali-metal halide and a transition-metal halide, which can further reduce the contact resistance.

Optionally, each of the material of the third work-function regulating layer and/or the work-function regulating material of the third transparent electrically conductive thin film may be independently selected from Ca, Mg, Ba, LiFₓ, KFₓ, MgFₓ, BaClₓ and so on. A person skilled in the art may select a suitable value of the x in the chemical formula according to practical situations.

Optionally, the work function of the work-function regulating material of the third transparent electrically conductive thin film is 1eV-5.5eV, which can further reduce the contact resistance.

Optionally, the light facing face of the silicon substrate may also be provided with at least one of a passivation layer, a front-face field-effect layer, a front-face antireflective-thin-film layer, a scattering-structure layer and a light-focusing-structure layer. Additionally or alternatively, if the second electrode is correspondingly provided on the second-charge-carrier collecting end, at the shadow face of the metal-chalcogen-compound layer, both of the part outside the first electrode and the part outside the second electrode within the second region are provided with a shadow-face antireflective film. Additionally or alternatively, if the second electrode is correspondingly provided on the second-charge-carrier selecting layer, at the shadow face of the metal-chalcogen-compound layer and the shadow face of the second-charge-carrier selecting layer, the part outside the first electrode and the second electrode is provided with a shadow-face antireflective film, to realize passivation, optical improvement and so on.

For example, referring to FIG. 10 to 13, 7 may be a front-face antireflective-thin-film layer, and 8 may be a shadow-face antireflective film.

Optionally, the second-charge-carrier selecting layer is one or more layers. The thickness of the second-charge-carrier selecting layer is unrelated to the thickness of the metal-chalcogen-compound layer. The thickness of the second-charge-carrier selecting layer 22 may be slightly greater than the height of the opening. For example, the thickness of the second-charge-carrier selecting layer is 1-500nm. More preferably, the thickness of the second-charge-carrier selecting layer is 2-60nm. The second-charge-carrier selecting layer 22 of such a thickness is beneficial to the transferring of the first charge carrier.

Optionally, if the silicon substrate is an N-type silicon substrate and the second charge carrier is a majority carrier, or if the silicon substrate is a P-type silicon substrate and the second charge carrier is a minority carrier, the material of the second-charge-carrier selecting layer is selected from a crystalline-silicon material of a work function greater than or equal to 3eV, an amorphous-silicon material of a work function greater than or equal to 3eV, and at least one of second materials, wherein the second materials are a metal-chalcogen-compound layer of a work function greater than or equal to 3eV. The second-charge-carrier selecting layer of such materials has a good effect of the collection and transferring of the second charge carrier.

Optionally, if the silicon substrate is a P-type silicon substrate and the second charge carrier is a majority carrier, or if the silicon substrate is an N-type silicon substrate and the second charge carrier is a minority carrier, the material of the second-charge-carrier selecting layer may be selected from at least one of first materials, wherein the first materials are an N-type metal-chalcogen-compound layer of a work function greater than or equal to 5eV, or a P-type metal-chalcogen-compound layer of a work function less than or equal to 6eV. The second-charge-carrier selecting layer of such materials has a good effect of the collection and transferring of the second charge carrier.

The particular selection of the second materials and the first materials may refer to the relevant description in the above embodiments, to obtain the same or similar advantageous effects, which, in order to avoid replication, is not discussed herein further.

Optionally, referring to FIG. 14, FIG. 14 shows a schematic structural diagram of the fourteenth type of back-contacting solar cell according to an embodiment of the present disclosure. The second region 2 is doped to form a second-charge-carrier collecting end. The second-charge-carrier collecting end can realize the collection and transferring of the second charge carrier. It should be noted that the doping types of the second region 2 and the second region itself of the silicon substrate 1 are the same, but the doping elements may be the same or different, which is not particularly limited in the embodiments of the present disclosure.

In FIG. 14, the metal-chalcogen-compound layer 4 is deposited on the whole shadow face of the silicon substrate 1, which, as compared with other material layers deposited on the whole shadow face of the silicon substrate 1, has a good adjustability in the structure and the performance, can realize a lower transverse-conduction capacity and a higher longitudinal-conduction capacity, and has a good thermal stability, and a wide window of process selection.

In FIG. 14, the metal-chalcogen-compound layer 4 has a blocking component 9 that electrically segments the metal-chalcogen-compound layer 4 into a second-charge-carrier transferring region and the first-charge-carrier collecting end. The quantity of the blocking component 9 is not particularly limited. The first-charge-carrier collecting end is located at the part that corresponds to the first region of the shadow face of the silicon substrate 1. The first-charge-carrier collecting end can realize the collection and transferring of the first charge carrier. The second-charge-carrier transferring region is located at the part that corresponds to the second region of the shadow face of the silicon substrate 1. The second-charge-carrier transferring region can realize the transferring of the second charge carrier.

The first-charge-carrier collecting end is correspondingly provided with a first electrode 5, and the first electrode 5 is used to conduct a first charge carrier. The second-charge-carrier transferring region is correspondingly provided with a second electrode 6, and the second electrode 6 is used to conduct a second charge carrier. It should be noted that an electrically insulating gap is required to be left between the first electrode 5 and the second electrode 6, wherein the electrically insulating gap is not smaller than the breakdown distance under the normal working voltage. The first electrode 5 and the second electrode 6 may be fabricated by printing, deposition and so on. The second electrode 6 and the first electrode 5 may be metal electrodes.

Referring to FIG. 14, if the silicon substrate 1 is an N-type silicon substrate, if the first charge carrier is holes, the second charge carrier is electrons. The second-charge-carrier collecting end is the electron collecting region. The second-charge-carrier collecting end is of a doped structure, which can cause that the energy band of the N-type silicon substrate bends downwardly within the second region 2, to attract electrons and reject holes, to serve for the selective collection of electrons. The first-charge-carrier collecting end is the hole collecting region. The first-charge-carrier collecting end behaves as a hole selectively-contacting material. The conduction-band energy level of that material is close to the valence-band energy level of the N-type silicon substrate, and the material can have interface defects of negative charges or negative fixing, which can cause that the energy band at the interface bends upwardly, to form an interface P-type layer, to serve to attract holes and reject electrons.

It should be noted that the conduction-band energy level and the valence-band energy level described above generally refer to the energy levels of the material itself, i.e., the energy levels when the material exists solely, and do not refer to the actual energy levels in the cell.

In FIG. 14, within the second-charge-carrier transferring region, because this part has a higher electron density, and a lower hole density, the conduction-band-bottom energy level of this part is low, and is close to the conduction-band-bottom energy level of the second-charge-carrier collecting end. Therefore, the electrons can directly enter the second-charge-carrier transferring region in the metal-chalcogen-compound layer that corresponds to the second-charge-carrier collecting end, thereby realizing the transferring of the electrons.

In FIG. 14, if the silicon substrate 1 is an N-type silicon substrate, if the first charge carrier is holes, the second charge carrier is electrons. In the metal-chalcogen-compound layer 4, the two parts electrically segmented by the blocking component 9 can individually realize the collection of the holes and the transferring of the electrons. In addition, the material may have a low transverse-electric-conduction capacity by regulating the crystallization performance, the crystalline phase and the doping element. Regarding the holes at the first-charge-carrier collecting end and the electrons at the second-charge-carrier transferring region, because of the electric segmentation by the blocking component 9, all of the different types of charge carriers, after collected, are longitudinally transferred to enter the corresponding electrodes, and are not communicated with each other due to transverse transferring to cause electric leakage or short circuiting. Therefore, the different types of charge-carrier collecting ends do not require additional electric isolation, and do not contact each other to generate a reverse PN junction.

In FIG. 14, the second-charge-carrier collecting end employs a locally doped selective-contacting structure, and the metal-chalcogen-compound layer 4 employs a deposited selective-contacting structure, which, as compared with the traditional full-diffusion back-contacting structure, has the advantage of a low body-region recombination, and has fewer diffusion steps and a simpler process. As compared with the structure using amorphous silicon as the back contacting, the metal-chalcogen-compound layer 4 has a higher selectivity, and a higher thermal stability, and the process of the material deposition has lower requirements on the equipment, and a higher safety. The metal-chalcogen-compound layer 4 can fully cover the back face of the cell, to further simplify the process.

In FIG. 14, by forming the first-charge-carrier collecting end by using the part of the metal-chalcogen-compound layer 4 that corresponds to the first region, as compared with amorphous-silicon materials, the first-charge-carrier collecting end has higher selectivity and longitudinal-transferring capacity, and a higher capacity of the collection and longitudinal transferring of the first charge carrier, which can realize a lower contact resistance. In addition, at the second-charge-carrier collecting end, cooperating with the locally doped structure, the second charge carrier is transferred via the band edge of the oxide material, which does not involve the trans-energy-level tunneling mechanism, and therefore the transferring of the second charge carrier has little obstruction, which can realize a lower contact resistance.

Optionally, the blocking component is a groove; and/or the blocking component is an insulator. The blocking component in such forms does not only have a good effect of blocking, but also is simple to fabricate. For example, the insulator may be provided by means of ion implantation.

Optionally, the thickness of the blocking component is greater than or equal to the thickness of the metal-chalcogen-compound layer, thereby having a good effect of electric blocking. For example, referring to FIG. 14, accordingly, the thickness of the blocking component 9 is equal to the thickness of the metal-chalcogen-compound layer 4. If the thickness of the blocking component is greater than the thickness of the metal-chalcogen-compound layer, the blocking component protrudes toward the shadow face of the metal-chalcogen-compound layer.

For example, referring to FIG. 15, on the basis of FIG. 14, the thickness of the blocking component 9 is greater than the thickness of the metal-chalcogen-compound layer 4, and the blocking component 9 protrudes toward the shadow face of the metal-chalcogen-compound layer 4.

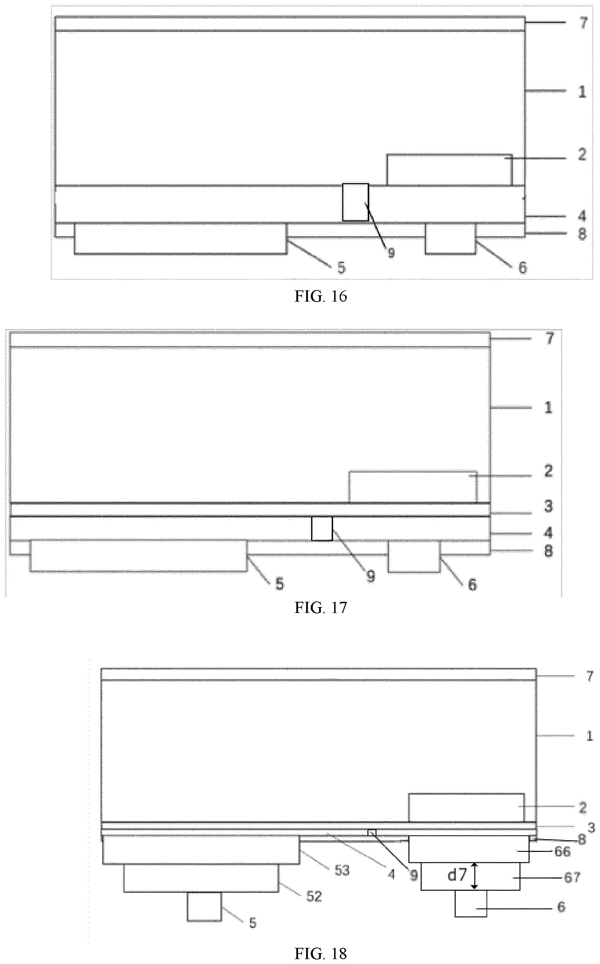

Referring to FIG. 16, FIG. 16 shows a schematic structural diagram of the sixteenth type of back-contacting solar cell according to an embodiment of the present disclosure. On the basis of FIG. 14, in FIG. 16, 7 may be a front-face antireflective-thin-film layer, and 8 may be a back-face antireflective film.

Referring to FIG. 17, FIG. 17 shows a schematic structural diagram of the seventeenth type of back-contacting solar cell according to an embodiment of the present disclosure. On the basis of FIG. 16, a tunneling isolating layer 3 is provided between the shadow face of the silicon substrate 1 and the metal-chalcogen-compound layer 4, and the thickness of the tunneling isolating layer 3 is 0.1nm-5nm. The material and so on of the tunneling isolating layer 3 refer to the above relevant description.

Optionally, a fourth transparent electrically conductive thin film and/or a fourth work-function regulating layer are provided between the second-charge-carrier transferring region and the second electrode. In other words, the fourth transparent electrically conductive thin film, or the fourth work-function regulating layer, or both of them, may be provided between the second-charge-carrier transferring region and the second electrode. Both of the fourth transparent electrically conductive thin film and/or the fourth work-function regulating layer are located within a projection region of the second-charge-carrier transferring region. It should be noted that, if both of them are provided, the fourth transparent electrically conductive thin film may be located on the shadow face or the light facing face of the fourth work-function regulating layer. The projection of the second electrode may be located within the projection of the fourth transparent electrically conductive thin film and/or the fourth work-function regulating layer.

The fourth transparent electrically conductive thin film can serve to assist the transferring of the charge carriers, and is light-transmitting, which can further increase the photoelectric conversion efficiency. The fourth work-function regulating layer serves to reduce the contact resistance.

FIG. 18 shows a schematic structural diagram of the eighteenth type of back-contacting solar cell according to an embodiment of the present disclosure. For example, referring to FIG. 18, a fourth transparent electrically conductive thin film 67 and a fourth work-function regulating layer 66 are provided between the second-charge-carrier transferring region and the second electrode 6. The fourth transparent electrically conductive thin film 67 is located at the shadow face of the fourth work-function regulating layer 66. A first transparent electrically conductive thin film 52 and a first work-function regulating layer 53 are provided between the first-charge-carrier collecting end and the first electrode 5. The first transparent electrically conductive thin film 52 is located at the shadow face of the first work-function regulating layer 53.

Optionally, referring to FIG. 18, the thickness d7 of the fourth transparent electrically conductive thin film 67 is 0.1-2nm. Such a thickness range can reduce the contact resistance to a larger extent.

Optionally, the fourth transparent electrically conductive thin film is formed by compounding or mixing a transparent electrically conductive material and a work-function regulating material. Additionally or alternatively, the first transparent electrically conductive thin film is formed by compounding or mixing a transparent electrically conductive material and a work-function regulating material. In other words, the first transparent electrically conductive thin film and the fourth transparent electrically conductive thin film cannot only serve to assist the transferring of the charge carriers, but also are light-transmitting, which can further increase the photoelectric conversion efficiency, and can reduce the contact resistance or the longitudinal resistance.

Optionally, if the fourth transparent electrically conductive thin film is provided between the second-charge-carrier transferring region and the second electrode, the second electrode is provided at the shadow face of the fourth transparent electrically conductive thin film in the form of grid lines, to sufficiently utilize the light transmission of the back face, which can further increase the photoelectric conversion efficiency.

Additionally or alternatively, if the first transparent electrically conductive thin film is provided between the first-charge-carrier collecting end and the first electrode, the first electrode is provided at the shadow face of the first transparent electrically conductive thin film in the form of grid lines, to sufficiently utilize the light transmission of the back face, which can further increase the photoelectric conversion efficiency.

Optionally, the material of the fourth transparent electrically conductive thin film is selected from at least one of zinc oxide, aluminum-doped zinc oxide, tin oxide, indium-doped tin oxide and indium-gallium-doped tin oxide. The fourth transparent electrically conductive thin film of such materials has a better performance of transferring the charge carriers, which can further increase the photoelectric conversion efficiency.

Optionally, the work function of the fourth work-function regulating layer is 1eV-5.5eV, which can further reduce the contact resistance.

Optionally, each of the material of the fourth work-function regulating layer and the work-function regulating material of the fourth transparent electrically conductive thin film may be independently selected from at least one of an alkali metal, a transition metal, an alkali-metal halide and a transition-metal halide, which can further reduce the contact resistance.

Optionally, each of the material of the fourth work-function regulating layer and the work-function regulating material of the fourth transparent electrically conductive thin film may be independently selected from Ca, Mg, Ba, LiFₓ, KFₓ, MgFₓ, BaClₓ and so on. A person skilled in the art may select a suitable value of the x in the chemical formula according to practical situations.

Optionally, the work functions of the material of the fourth work-function regulating layer and/or the work-function regulating material of the fourth transparent electrically conductive thin film are 1eV-5.5eV, which can further reduce the contact resistance.

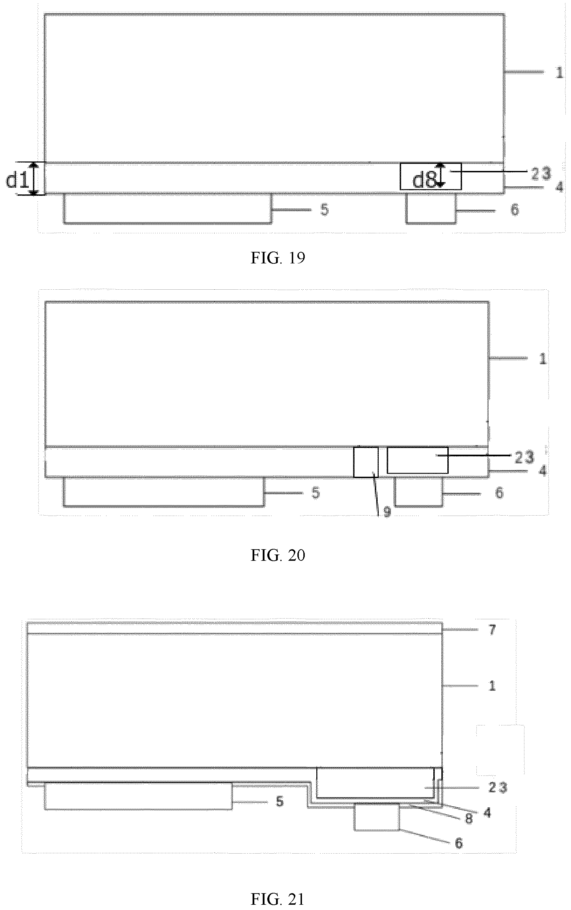

Optionally, referring to FIG. 19, FIG. 19 shows a schematic structural diagram of the nineteenth type of back-contacting solar cell according to an embodiment of the present disclosure. A second-charge-carrier selectively-collecting layer 23 is deposited within the second region of the shadow face of the silicon substrate 1. The second-charge-carrier selectively-collecting layer 23 can realize the collection and transferring of the second charge carrier. The metal-chalcogen-compound layer 4 is deposited on the shadow face shared by the silicon substrate 1 and the second-charge-carrier selectively-collecting layer 23. The metal-chalcogen-compound layer 4 has a good adjustability in the structure and the performance, can realize a lower transverse-conduction capacity and a higher longitudinal-conduction capacity, and has a good thermal stability, and a wide window of process selection.

The part of the metal-chalcogen-compound layer 4 that corresponds to the second-charge-carrier selectively-collecting layer 23 forms the second-charge-carrier transferring region, which can realize the transferring of the second charge carrier. The part of the metal-chalcogen-compound layer 4 that corresponds to the first region of the silicon substrate 1 forms the first-charge-carrier collecting end, which can realize the collection and transferring of the first charge carrier.

Optionally, the area of the projection of the second-charge-carrier selectively-collecting layer 23 on the shadow face of the silicon substrate 1 accounts for 5% to 45% of the total area of the shadow face of the silicon substrate. That area proportion results in a good effect of the collection and transferring of the second charge carrier, and at the same time does not affect the collection and transferring of the first charge carrier.

Optionally, a top view of the second-charge-carrier selectively-collecting layer 23 may be a punctate pattern or a linear pattern. The punctate pattern is, for example, a circle or an ellipse. The linear pattern is, for example, a rectangle, a polygon and so on. The top view of the second-charge-carrier selectively-collecting layer 23 is a punctate pattern or a linear pattern, which results in a simple process to realize the deposition of the second-charge-carrier selectively-collecting layer 23.

In the metal-chalcogen-compound layer 4 the shadow face of the first-charge-carrier collecting end is correspondingly provided with a first electrode 5, and the first electrode 5 is used to conduct a first charge carrier. The second-charge-carrier transferring region is correspondingly provided with a second electrode 6, and the second electrode 6 is used to conduct a first charge carrier. It should be noted that an electrically insulating gap is required to be left between the first electrode 5 and the second electrode 6, wherein the electrically insulating gap is not smaller than the breakdown distance under the normal working voltage. The first electrode 5 and the second electrode 6 may be fabricated by printing, deposition and so on. The second electrode 6 and the first electrode 5 may be metal electrodes.

Referring to FIG. 19, if the silicon substrate 1 is an N-type silicon substrate, if the second charge carrier is electrons, the first charge carrier is holes. The second-charge-carrier selectively-collecting layer 23 is the electron collecting end. The second-charge-carrier selectively-collecting layer is of a deposited structure, and its conduction-band energy level is close to the conduction-band energy level of the silicon material, which can cause that the energy band of the N-type silicon substrate bends downwardly in the second-charge-carrier selectively-collecting layer 23, to attract electrons and reject holes, to serve for the selective collection of electrons. The part of the metal-chalcogen-compound layer 4 that corresponds to the first region of the silicon substrate 1 forms the first-charge-carrier collecting end, and the first-charge-carrier collecting end is the hole collecting end. The first-charge-carrier collecting end behaves as a hole selectively-contacting material. The conduction-band energy level of that material is close to the valence-band energy level of the N-type silicon substrate, and the material can have interface defects of negative charges or negative fixing, which can cause that the energy band at the interface bends upwardly, to form an interface P-type layer, to serve to attract holes and reject electrons.

It should be noted that the conduction-band energy level and the valence-band energy level according to the present disclosure generally refer to the energy levels of the material itself, i.e., the energy levels when the material exists solely, and do not refer to the actual energy levels in the cell.

In FIG. 19, within the second-charge-carrier transferring region, the conduction-band-bottom energy level of the second-charge-carrier selectively-collecting layer 23 is located between the conduction-band energy level of the silicon substrate 1 and the conduction-band energy level of the metal-chalcogen-compound layer 4. Therefore, the electrons in the silicon substrate 1 can directly sequentially enter the second-charge-carrier selectively-collecting layer 23 and then enter the second-charge-carrier transferring region of the metal-chalcogen-compound layer 4 that corresponds to the second-charge-carrier selectively-collecting layer 23, thereby realizing the transferring of the electrons.

In FIG. 19, the metal-chalcogen-compound layer 4 can realize both of the collection of the holes and the transferring of the electrons. In addition, in the metal-chalcogen-compound layer 4, the interface between the second-charge-carrier transferring region and the first-charge-carrier collecting end has a high-resistance defect, which can realize insulation, and all of the different types of charge carriers, after collected, are longitudinally transferred to enter the corresponding electrodes, in order not to have electric leakage or short circuiting. Therefore, the different types of charge-carrier collecting ends do not require additional electric isolation, and do not contact each other to generate a reverse PN junction.

In FIG. 19, the second-charge-carrier selectively-collecting layer employs a deposited selective-contacting structure, and the metal-chalcogen-compound layer 4 also employs a deposited selective-contacting structure, which, as compared with the traditional full-diffusion structure, has the advantage of a low body-region recombination, is not limited by the limit of auger recombination, and has fewer diffusion steps and a simpler process. Additionally, both of the second-charge-carrier selectively-collecting layer and the metal-chalcogen-compound layer are formed by deposition, which does not require a high temperature. As compared with the structure using amorphous silicon as the back contacting, the metal-chalcogen-compound layer 4 has a higher selectivity, and a higher thermal stability, and the process of the material deposition has lower requirements on the equipment, and a higher safety. The metal-chalcogen-compound layer 4 can fully cover the back face of the cell, to further simplify the process.

By forming the first-charge-carrier collecting end by using the part of the metal-chalcogen-compound layer 4 that corresponds to the first region of the silicon substrate 1, as compared with amorphous-silicon materials, the first-charge-carrier collecting end has higher selectivity and longitudinal-transferring capacity, and a higher capacity of the collection and longitudinal transferring of the first charge carrier.

Optionally, referring to FIG. 20, FIG. 20 shows a schematic structural diagram of the twentieth type of back-contacting solar cell according to an embodiment of the present disclosure. In the metal-chalcogen-compound layer 4, a blocking component 9 is provided between the second-charge-carrier transferring region and the first-charge-carrier collecting end. The blocking component 9 electrically segments the second-charge-carrier transferring region and the first-charge-carrier collecting end in the metal-chalcogen-compound layer, which can increase the electric conductivity of the metal chalcogen compound within the un-segmented region, which can reduce the longitudinal series resistance to a large extent. Furthermore, by electrically segmenting the second-charge-carrier transferring region and the first-charge-carrier collecting end by using the blocking component, all of the different types of charge carriers, after collected, are longitudinally transferred to enter the corresponding electrodes, and are not communicated with each other due to transverse transferring to cause electric leakage or short circuiting. Therefore, no additional alignment and electric isolation are required, which results in a simple process, reduces recombination, and increases the photoelectric conversion efficiency.

Optionally, the blocking component is a groove; and/or the blocking component is a high-resistance body, wherein the electric resistivity of the high-resistance body is not less than 100 times of the electric resistivity of the metal-chalcogen-compound layer 4. That, in an aspect, has a good effect of insulation, and, in another aspect, can be simply fabricated.

Optionally, the light facing face of the silicon substrate may also be provided with at least one of a passivation layer, a front-face field-effect layer, a front-face antireflective-thin-film layer, a scattering-structure layer and a light-focusing-structure layer. Additionally or alternatively, at the shadow faces of the metal-chalcogen-compound layer and the second-charge-carrier transferring region, a back-face antireflective film is provided within a region outside the first electrode and the second electrode, to realize passivation, optical improvement and so on.

Referring to FIG. 21, FIG. 21 shows a schematic structural diagram of the twenty-first type of back-contacting solar cell according to an embodiment of the present disclosure. In FIG. 21, 7 may be a front-face antireflective-thin-film layer, and 8 may be a back-face antireflective film.

Optionally, referring to FIG. 19, the thickness d8 of the second-charge-carrier selectively-collecting layer 23 is 1-500nm. More preferably, d8 is 2-60nm. The second-charge-carrier selectively-collecting layer 23 of such a thickness is beneficial to the collection and transferring of the second charge carrier.

Optionally, if the silicon substrate is an N-type silicon substrate and the second charge carrier is a majority carrier, or if the silicon substrate is a P-type silicon substrate and the second charge carrier is a minority carrier, the material of the second-charge-carrier selectively-collecting layer is selected from a crystalline-silicon material of a work function greater than or equal to 3eV, an amorphous-silicon material of a work function greater than or equal to 3eV, and at least one of second materials, wherein the second materials are metal chalcogen compounds of a work function greater than or equal to 3eV. The second-charge-carrier selectively-collecting layer of such materials has a good effect of the collection and transferring of the second charge carrier.

Optionally, if the silicon substrate is a P-type silicon substrate and the second charge carrier is a majority carrier, or if the silicon substrate is an N-type silicon substrate and the second charge carrier is a minority carrier, the material of the second-charge-carrier selectively-collecting layer may be selected from at least one of first materials, wherein the first materials are N-type metal chalcogen compounds of a work function greater than or equal to 5eV, or P-type metal chalcogen compounds of a work function less than or equal to 6eV. The second-charge-carrier selectively-collecting layer of such materials has a good effect of the collection and transferring of the second charge carrier.

The particular selection of the second materials and the first materials may refer to the relevant description in the above embodiments, to obtain the same or similar advantageous effects, which, in order to avoid replication, is not discussed herein further.

Optionally, a tunneling isolating layer is provided between the shadow face of the silicon substrate and a light facing face shared by the metal-chalcogen-compound layer and the second-charge-carrier selectively-collecting layer. The material, the thickness, the function and so on of the tunneling isolating layer may refer to the above description.

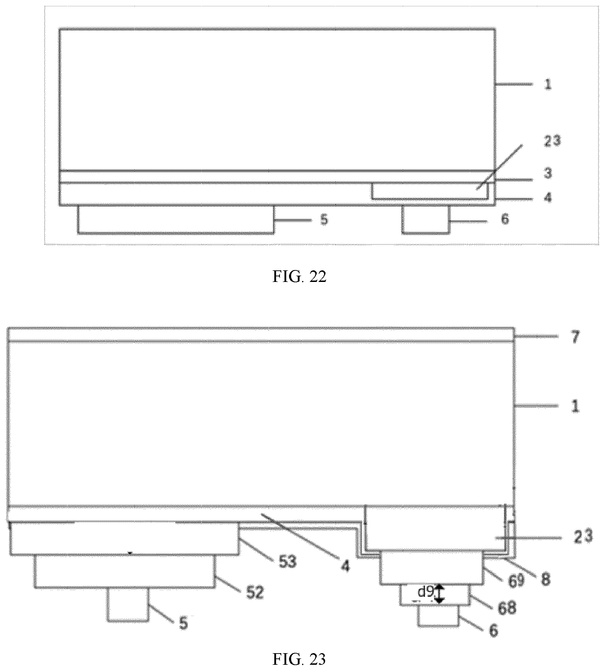

Referring to FIG. 22, FIG. 22 shows a schematic structural diagram of the twenty-second type of back-contacting solar cell according to an embodiment of the present disclosure. A tunneling isolating layer 3 is provided between the shadow face of the silicon substrate 1 and a light facing face shared by the metal-chalcogen-compound layer 4 and the second-charge-carrier selectively-collecting layer 23.

Optionally, a fifth transparent electrically conductive thin film and/or a fifth work-function regulating layer are provided between the second electrode and the second-charge-carrier selectively-collecting layer. In other words, the fifth transparent electrically conductive thin film, or the fifth work-function regulating layer, or both of them, may be provided between the second electrode and the second-charge-carrier selectively-collecting layer. Both of the fifth transparent electrically conductive thin film and/or the fifth work-function regulating layer are located within a projection region of the second-charge-carrier selectively-collecting layer. It should be noted that, if both of them are provided, the fifth transparent electrically conductive thin film may be located on the shadow face or the light facing face of the fifth work-function regulating layer. The projection of the second electrode may be located within the projection of the fifth transparent electrically conductive thin film and/or the fifth work-function regulating layer.

Additionally or alternatively, a first transparent electrically conductive thin film and/or a first work-function regulating layer are provided between the first-charge-carrier collecting end and the first electrode. In other words, the first transparent electrically conductive thin film, or the first work-function regulating layer, or both of them, may be provided between the first-charge-carrier collecting end and the first electrode. Both of the first transparent electrically conductive thin film and/or the first work-function regulating layer are located within a projection region of the first-charge-carrier collecting end and the first electrode. It should be noted that, if both of them are provided, the first transparent electrically conductive thin film may be located on the shadow face or the light facing face of the first work-function regulating layer. The projection of the first electrode may be located within the projection of the first transparent electrically conductive thin film and/or the first work-function regulating layer.

The fifth transparent electrically conductive thin film and the first transparent electrically conductive thin film can serve to assist the transferring of the charge carriers, and are light-transmitting, which can further increase the photoelectric conversion efficiency. The first work-function regulating layer and the fifth work-function regulating layer serve to reduce the contact resistance.

FIG. 23 shows a schematic structural diagram of the twenty-third type of back-contacting solar cell according to an embodiment of the present disclosure. For example, referring to FIG. 23, a fifth transparent electrically conductive thin film 69 and a fifth work-function regulating layer 68 are provided between the second-charge-carrier selectively-collecting layer 23 and the second electrode 6. The fifth transparent electrically conductive thin film 69 is located at the light facing face of the fifth work-function regulating layer 68. A first transparent electrically conductive thin film 52 and a first work-function regulating layer 53 are provided between the first-charge-carrier collecting end and the first electrode 5. The first transparent electrically conductive thin film 52 is located at the shadow face of the first work-function regulating layer 53.

Optionally, referring to FIG. 23, the thickness d9 of the fifth work-function regulating layer 68 is 0.1-2nm. Such a thickness range can reduce the contact resistance to a larger extent.

Optionally, the fifth transparent electrically conductive thin film is formed by compounding or mixing a transparent electrically conductive material and a work-function regulating material. Additionally or alternatively, the first transparent electrically conductive thin film is formed by compounding or mixing a transparent electrically conductive material and a work-function regulating material. In other words, the fifth transparent electrically conductive thin film and the first transparent electrically conductive thin film cannot only serve to assist the transferring of the charge carriers, but also are light-transmitting, which can further increase the photoelectric conversion efficiency, and can reduce the contact resistance or the longitudinal resistance.

Optionally, if the fifth transparent electrically conductive thin film is provided between the second-charge-carrier selectively-collecting layer and the second electrode, the second electrode is provided at the shadow face of the fifth transparent electrically conductive thin film in the form of grid lines, to sufficiently utilize the light transmission of the back face, which can further increase the photoelectric conversion efficiency.

Additionally or alternatively, if the first transparent electrically conductive thin film is provided between the first electrode and the first-charge-carrier collecting end, the first electrode is provided at the shadow face of the first transparent electrically conductive thin film in the form of grid lines, to sufficiently utilize the light transmission of the back face, which can further increase the photoelectric conversion efficiency.

Optionally, the material of the fifth transparent electrically conductive thin film is selected from at least one of zinc oxide, aluminum-doped zinc oxide, tin oxide, indium-doped tin oxide and indium-gallium-doped tin oxide. The fifth transparent electrically conductive thin film of such materials has a better performance of transferring the charge carriers, which can further increase the photoelectric conversion efficiency.

Optionally, the work function of the fifth work-function regulating layer is 1eV-5.5eV, which can further reduce the contact resistance.

Optionally, each of the material of the fifth work-function regulating layer and the work-function regulating material of the fifth transparent electrically conductive thin film may be independently selected from at least one of an alkali metal, a transition metal, an alkali-metal halide and a transition-metal halide, which can further reduce the contact resistance.

Optionally, each of the material of the fifth work-function regulating layer and the work-function regulating material of the fifth transparent electrically conductive thin film may be independently selected from Ca, Mg, Ba, LiFₓ, KFₓ, MgFₓ, BaClₓ and so on. A person skilled in the art may select a suitable value of the x in the chemical formula according to practical situations.

Optionally, the work function of the work-function regulating material of the fifth transparent electrically conductive thin film is 1eV-5.5eV, which can further reduce the contact resistance.

An embodiment of the present disclosure further provides a method for producing a back-contacting solar cell, wherein the method comprises the following steps:
Step S1: providing a silicon substrate, wherein a shadow face of the silicon substrate is delimited into a first region and a second region.
Step S2: depositing within at least the first region of the silicon substrate to obtain a metal-chalcogen-compound layer, wherein a region of the metal-chalcogen-compound layer that corresponds to the first region forms a first-charge-carrier collecting end.
Step S3: correspondingly providing a first electrode on the first-charge-carrier collecting end, wherein a region of the metal-chalcogen-compound layer that corresponds to the second region forms a second-charge-carrier transferring region.
Step S4: correspondingly providing a second electrode within a region that corresponds to the second region.

Optionally, before the step S2, the method may further comprise: doping the silicon substrate within the second region, to form a second-charge-carrier collecting end. The step S2 may comprise: depositing on the whole shadow face of the silicon substrate to obtain the metal-chalcogen-compound layer, wherein a region of the metal-chalcogen-compound layer that corresponds to the second region forms a second-charge-carrier transferring region. The Step S4 comprises: correspondingly providing the second electrode within the second-charge-carrier transferring region.

The silicon substrate, the second-charge-carrier collecting end, the first-charge-carrier collecting end, the second-charge-carrier transferring region, the second electrode and the first electrode in the steps of the method may particularly refer to the relevant description in the above embodiments, to obtain the same or similar advantageous effects, which, in order to avoid replication, is not discussed herein further.

An embodiment of the present disclosure further provides a back-contacting cell assembly, wherein the back-contacting cell assembly comprises: the back-contacting solar cell according to any one of the above-described embodiments. The silicon substrate, the second-charge-carrier collecting end, the first-charge-carrier collecting end, the second-charge-carrier transferring region, the second electrode and the first electrode in the assembly may particularly refer to the relevant description in the above embodiments, to obtain the same or similar advantageous effects, which, in order to avoid replication, is not discussed herein further.

The embodiments of the present disclosure are described above with reference to the drawings. However, the present disclosure is not limited to the above particular embodiments. The above particular embodiments are merely illustrative, rather than limitative. A person skilled in the art, under the motivation of the present disclosure, can make many variations without departing from the spirit of the present disclosure and the protection scope of the claims, and all of the variations fall within the protection scope of the present disclosure.

The "one embodiment", "an embodiment" or "one or more embodiments" as used herein means that particular features, structures or characteristics described with reference to an embodiment are included in at least one embodiment of the present disclosure. Moreover, it should be noted that here an example using the wording "in an embodiment" does not necessarily refer to the same one embodiment.

The description provided herein describes many concrete details. However, it can be understood that the embodiments of the present disclosure may be implemented without those concrete details. In some of the embodiments, well-known processes, structures and techniques are not described in detail, so as not to affect the understanding of the description.

Finally, it should be noted that the above embodiments are merely intended to explain the technical solutions of the present disclosure, and not to limit them. Although the present disclosure is explained in detail with reference to the above embodiments, a person skilled in the art should understand that he can still modify the technical solutions set forth by the above embodiments, or make equivalent substitutions to part of the technical features of them. However, those modifications or substitutions do not make the essence of the corresponding technical solutions depart from the spirit and scope of the technical solutions of the embodiments of the present disclosure.

## Claims

1. A back-contacting solar cell, wherein the back-contacting solar cell comprises:
a silicon substrate, wherein a shadow face of the silicon substrate is delimited into a first region and a second region;
a metal-chalcogen-compound layer, wherein the metal-chalcogen-compound layer is deposited within at least the first region of the silicon substrate, and a region of the metal-chalcogen-compound layer that corresponds to the first region forms a first-charge-carrier collecting end;
a first electrode, wherein the first electrode is correspondingly provided on the first-charge-carrier collecting end; and
a second electrode, wherein the second electrode is correspondingly provided within a region that corresponds to the second region.

2. The back-contacting solar cell according to claim 1, wherein
the silicon substrate within the second region is doped to form a second-charge-carrier collecting end;
the metal-chalcogen-compound layer is deposited on the whole shadow face of the silicon substrate;
a region of the metal-chalcogen-compound layer that corresponds to the second region forms a second-charge-carrier transferring region; and
the second electrode is correspondingly provided within the second-charge-carrier transferring region.

3. The back-contacting solar cell according to claim 1, wherein
the silicon substrate within the second region is doped to form a second-charge-carrier collecting end; the metal-chalcogen-compound layer is deposited merely within the first region; and the second electrode is correspondingly provided on the second-charge-carrier collecting end;
or
the metal-chalcogen-compound layer is deposited on the whole shadow face of the silicon substrate; at least a part of the metal-chalcogen-compound layer that corresponds to the second region has an opening that electrically segments the metal-chalcogen-compound layer; a second-charge-carrier selecting layer is formed at the part of the metal-chalcogen-compound layer that corresponds to the second region, and the second-charge-carrier selecting layer fills the opening; and the second electrode is correspondingly provided on the second-charge-carrier selecting layer.

4. The back-contacting solar cell according to claim 1, wherein
the silicon substrate within the second region is doped to form a second-charge-carrier collecting end;
the metal-chalcogen-compound layer is deposited on the whole shadow face of the silicon substrate;
the metal-chalcogen-compound layer has a blocking component that electrically segments the metal-chalcogen-compound layer into a second-charge-carrier transferring region and the first-charge-carrier collecting end;
the second-charge-carrier transferring region corresponds to the second region; and
the second electrode is correspondingly provided within the second-charge-carrier transferring region.

5. The back-contacting solar cell according to claim 1, wherein the back-contacting solar cell further comprises: a second-charge-carrier selectively-collecting layer;
the second-charge-carrier selectively-collecting layer is deposited within the second region of the silicon substrate;
the metal-chalcogen-compound layer is deposited within the first region and on a shadow face of the second-charge-carrier selectively-collecting layer;
a part of the metal-chalcogen-compound layer that corresponds to the second-charge-carrier selectively-collecting layer forms a second-charge-carrier transferring region; and
the second electrode is correspondingly provided within the second-charge-carrier transferring region.

6. The back-contacting solar cell according to any one of claims 2-5, wherein
if the silicon substrate is an N-type silicon substrate and a second charge carrier is a majority carrier, or if the silicon substrate is a P-type silicon substrate and a second charge carrier is a minority carrier, a material of the metal-chalcogen-compound layer is selected from at least one of first materials, wherein the first materials are N-type metal chalcogen compounds of a work function greater than or equal to 5eV, or P-type metal chalcogen compounds of a work function less than or equal to 6eV; and
if the silicon substrate is a P-type silicon substrate and the second charge carrier is a majority carrier, or if the silicon substrate is an N-type silicon substrate and the second charge carrier is a minority carrier, the material of the metal-chalcogen-compound layer is selected from at least one of second materials, wherein the second materials are metal chalcogen compounds of a work function greater than or equal to 3eV.

7. The back-contacting solar cell according to any one of claims 2-4, wherein a doping concentration of the second-charge-carrier collecting end is greater than or equal to 10¹⁵ cm⁻³, and greater than a doping concentration of the silicon substrate within the first region; and
an area of a projection of the second-charge-carrier collecting end on the shadow face of the silicon substrate accounts for 5% to 45% of a total area of the shadow face of the silicon substrate.

8. The back-contacting solar cell according to any one of claims 2-5, wherein a second-charge-carrier selecting layer is deposited on the shadow face within the second region; and
the second-charge-carrier selecting layer is located on a shadow face or a light facing face of the metal-chalcogen-compound layer.

9. The back-contacting solar cell according to claim 8, wherein a thickness of the second-charge-carrier selecting layer is 1-500nm; and
an area of a projection of the second-charge-carrier selecting layer on the shadow face of the silicon substrate accounts for 5% to 45% of a total area of the shadow face of the silicon substrate.

10. The back-contacting solar cell according to claim 8, wherein
if the silicon substrate is an N-type silicon substrate and a second charge carrier is a majority carrier, or if the silicon substrate is a P-type silicon substrate and a second charge carrier is a minority carrier, a material of the second-charge-carrier selecting layer is selected from a crystalline-silicon material of a work function greater than or equal to 3eV, an amorphous-silicon material of a work function greater than or equal to 3eV, and at least one of second materials, wherein the second materials are metal chalcogen compounds of a work function greater than or equal to 3eV; and
if the silicon substrate is a P-type silicon substrate and the second charge carrier is a majority carrier, or if the silicon substrate is an N-type silicon substrate and the second charge carrier is a minority carrier, a material of the second-charge-carrier selecting layer is selected from at least one of first materials, wherein the first materials are N-type metal chalcogen compounds of a work function greater than or equal to 5eV, or P-type metal chalcogen compounds of a work function less than or equal to 6eV.

11. The back-contacting solar cell according to claim 6 or 10, wherein
the metal chalcogen compounds contain a doping element, and the doping element is selected from at least one of a halogen element, a transition-metal element, an alkali-metal element, a group-III element, a group-IV element and a group-V element.

12. The back-contacting solar cell according to claim 6 or 10, wherein
the second materials are selected from at least one of zinc oxide, tin oxide, titanium oxide, cupric oxide, thallium oxide, cadmium sulfide, molybdenum sulfide, zinc sulfide, molybdenum selenide, copper selenide, niobium-doped cupric oxide, cadmium germanium oxide, iridium zinc oxide and cobalt calcium oxide; and
the first materials are selected from at least one of molybdenum oxide, tungsten oxide, vanadium oxide, niobium oxide, nickel oxide, mercury-doped niobium oxide and mercury-doped tantalum oxide.

13. The back-contacting solar cell according to claim 2, wherein a transverse-conduction capacity of the metal-chalcogen-compound layer is less than or equal to 1.0×10⁻³S/cm.

14. The back-contacting solar cell according to claim 2, wherein if the silicon substrate is a P-type silicon substrate and the second charge carrier is a majority carrier, or if the silicon substrate is an N-type silicon substrate and the second charge carrier is a minority carrier,
a fixed-positive-charge density of the metal-chalcogen-compound layer is greater than or equal to 10¹¹ cm⁻²; and/or
an acceptor-defect density of the metal-chalcogen-compound layer is greater than or equal to 10¹¹ cm⁻¹; and/or
a limited-charge density of the metal-chalcogen-compound layer is greater than or equal to 10¹¹ cm⁻¹; and
if the silicon substrate is an N-type silicon substrate and the second charge carrier is a majority carrier, or if the silicon substrate is a P-type silicon substrate and a second charge carrier is a minority carrier,
a fixed-negative-charge density of the metal-chalcogen-compound layer is greater than or equal to 10¹² cm⁻²; and/or
a donor-defect density of the metal-chalcogen-compound layer is greater than or equal to 10¹² cm⁻¹; and/or
a limited-charge density of the metal-chalcogen-compound layer is greater than or equal to 10¹² cm⁻².

15. The back-contacting solar cell according to any one of claims 2-5, wherein an average light transmittance of the metal-chalcogen-compound layer within a visible-light wave band is greater than or equal to 70%; and
a thickness of the metal-chalcogen-compound layer is 1-600nm.

16. The back-contacting solar cell according to any one of claims 2-5, wherein a tunneling isolating layer is provided between the shadow face of the silicon substrate and the metal-chalcogen-compound layer; and
a thickness of the tunneling isolating layer is 0.1nm-5nm, and the tunneling isolating layer is one or more layers.

17. The back-contacting solar cell according to claim 16, wherein a material of the tunneling isolating layer is selected from at least one of an oxide of silicon, a nitride of silicon, an oxynitride of silicon and a halide of silicon.

18. The back-contacting solar cell according to claim 16, wherein a material of the tunneling isolating layer is a dielectric material, and a dielectric constant of the material of the tunneling isolating layer is greater than 2; and
a breakdown voltage of the tunneling isolating layer is greater than or equal to 3MV/cm.

19. The back-contacting solar cell according to claim 16, wherein a material of the tunneling isolating layer is selected from at least one of silicon oxide, silicon nitride, silicon fluoride, silicon fluoride oxide, silicon carbon oxide, aluminium oxide, aluminum fluoride and aluminum oxynitride.

20. The back-contacting solar cell according to any one of claims 2-4, wherein a second transparent electrically conductive thin film and/or a second work-function regulating layer are provided between the second-charge-carrier collecting end and the second electrode; and both of the second transparent electrically conductive thin film and/or the second work-function regulating layer are located within a projection region of the second-charge-carrier collecting end; and/or
a first transparent electrically conductive thin film and/or a first work-function regulating layer are provided between the first-charge-carrier collecting end and the first electrode; and both of the first transparent electrically conductive thin film and/or the first work-function regulating layer are located within a projection region of the first-charge-carrier collecting end.

21. The back-contacting solar cell according to claim 20, wherein both of thicknesses of the first work-function regulating layer and the second work-function regulating layer are 0.1-5nm;
both of work functions of the first work-function regulating layer and the second work-function regulating layer are 1eV-5.5eV; and
the first transparent electrically conductive thin film is formed by compounding or mixing a transparent electrically conductive material and a work-function regulating material; and/or the second transparent electrically conductive thin film is formed by compounding or mixing a transparent electrically conductive material and a work-function regulating material.

22. The back-contacting solar cell according to claim 20, wherein if the second transparent electrically conductive thin film is provided between the second-charge-carrier collecting end and the second electrode, the second electrode is provided at a shadow face of the second transparent electrically conductive thin film in the form of grid lines; and/or
if the first transparent electrically conductive thin film is provided between the first-charge-carrier collecting end and the first electrode, the first electrode is provided at a shadow face of the first transparent electrically conductive thin film in the form of grid lines.

23. The back-contacting solar cell according to claim 20, wherein each of materials of the first transparent electrically conductive thin film and the second transparent electrically conductive thin film is independently selected from at least one of zinc oxide, aluminum-doped zinc oxide, tin oxide, indium-doped tin oxide and indium-gallium-doped tin oxide.

24. The back-contacting solar cell according to claim 21, wherein a work function of the work-function regulating material is 1eV-5.5eV.

25. The back-contacting solar cell according to claim 20, wherein each of the first work-function regulating layer and the second work-function regulating layer is independently selected from at least one of an alkali metal, a transition metal, an alkali-metal halide and a transition-metal halide.

26. The back-contacting solar cell according to claim 20, wherein each of the first work-function regulating layer and the second work-function regulating layer is independently selected from at least one of calcium, magnesium, barium, lithium fluoride, potassium fluoride, magnesium fluoride and barium chloride.

27. The back-contacting solar cell according to any one of claims 2-5, wherein the shadow face of the silicon substrate is of a planar structure or a light trapping structure; and/or
a light facing face of the silicon substrate is of a planar structure or a light trapping structure.

28. The back-contacting solar cell according to any one of claims 2-4, wherein a top view of the second-charge-carrier collecting end is a punctate pattern or a linear pattern.

29. The back-contacting solar cell according to claim 2 or 4, wherein a light facing face of the silicon substrate is provided with at least one of a passivation layer, a front-face field-effect layer, a front-face antireflective-thin-film layer, a scattering-structure layer and a light-focusing-structure layer; and/or
at the shadow face of the metal-chalcogen-compound layer, a back-face passivating film is provided within a region outside the second electrode and the first electrode.

30. The back-contacting solar cell according to claim 3, wherein a projection of the second region and a projection of the second-charge-carrier selecting layer at least partially coincide; and
the second-charge-carrier selecting layer is located on a shadow face or a light facing face of the metal-chalcogen-compound layer.

31. The back-contacting solar cell according to claim 3 or 30, wherein
an area of a projection of the second-charge-carrier collecting end on the shadow face of the silicon substrate accounts for 5% to 45% of a total area of the shadow face of the silicon substrate; and
an area of a projection of the second-charge-carrier selecting layer on the shadow face of the silicon substrate accounts for 5% to 45% of the total area of the shadow face of the silicon substrate.

32. The back-contacting solar cell according to claim 3 or 30, wherein if the second electrode is correspondingly provided on the second-charge-carrier selecting layer, a third transparent electrically conductive thin film and/or a third work-function regulating layer are provided between the second-charge-carrier selecting layer and the second electrode; and
both of the third transparent electrically conductive thin film and/or the third work-function regulating layer are located within a projection part of the second-charge-carrier selecting layer.

33. The back-contacting solar cell according to claim 32, wherein
a thickness of the third work-function regulating layer is 0. 1-2nm.

34. The back-contacting solar cell according to claim 32, wherein
if the third transparent electrically conductive thin film is provided between the second-charge-carrier selecting layer and the second electrode, the second electrode is provided at a shadow face of the third transparent electrically conductive thin film in the form of grid lines.

35. The back-contacting solar cell according to claim 3 or 30, wherein
a light facing face of the silicon substrate is provided with at least one of a passivation layer, a front-face field-effect layer, a front-face antireflective-thin-film layer, a scattering-structure layer and a light-focusing-structure layer; and/or
if the second electrode is correspondingly provided on the second-charge-carrier collecting end, at the shadow face of the metal-chalcogen-compound layer, both of a part outside the first electrode and a part outside the second electrode within the second region are provided with a shadow-face antireflective film; and/or
if the second electrode is correspondingly provided on the second-charge-carrier selecting layer, at the shadow face of the metal-chalcogen-compound layer and a shadow face of the second-charge-carrier selecting layer, a part outside the first electrode and the second electrode is provided with a shadow-face antireflective film.

36. The back-contacting solar cell according to claim 4, wherein
the blocking component is a groove; and/or
the blocking component is an insulator.

37. The back-contacting solar cell according to claim 4 or 36, wherein a thickness of the blocking component is greater than or equal to a thickness of the metal-chalcogen-compound layer; and
if the thickness of the blocking component is greater than the thickness of the metal-chalcogen-compound layer, the blocking component protrudes toward a shadow face of the metal-chalcogen-compound layer.

38. The back-contacting solar cell according to claim 4 or 36, wherein
a fourth transparent electrically conductive thin film and/or a fourth work-function regulating layer are provided between the second-charge-carrier transferring region and the second electrode; and both of the fourth transparent electrically conductive thin film and/or the fourth work-function regulating layer are located within a projection region of the second-charge-carrier transferring region; and/or
a first transparent electrically conductive thin film and/or a first work-function regulating layer are provided between the first-charge-carrier collecting end and the first electrode; and both of the first transparent electrically conductive thin film and/or the first work-function regulating layer are located within a projection region of the first-charge-carrier collecting end.

39. The back-contacting solar cell according to claim 38, wherein
a thickness of the fourth transparent electrically conductive thin film is 0.1-2nm.

40. The back-contacting solar cell according to claim 38, wherein
if the fourth transparent electrically conductive thin film is provided between the second-charge-carrier transferring region and the second electrode, the second electrode is provided at a shadow face of the fourth transparent electrically conductive thin film in the form of grid lines; and/or
if the first transparent electrically conductive thin film is provided between the first-charge-carrier collecting end and the first electrode, the first electrode is provided at a shadow face of the first transparent electrically conductive thin film in the form of grid lines.

41. The back-contacting solar cell according to claim 5, wherein in the metal-chalcogen-compound layer, a blocking component is provided between the second-charge-carrier transferring region and the first-charge-carrier collecting end.

42. The back-contacting solar cell according to claim 41, wherein the blocking component is a groove; and/or
the blocking component is a high-resistance body, wherein an electric resistivity of the high-resistance body is not less than 100 times of an electric resistivity of the metal-chalcogen-compound layer.

43. The back-contacting solar cell according to claim 5 or 41, wherein a thickness of the second-charge-carrier selectively-collecting layer is 1-500nm.

44. The back-contacting solar cell according to claim 5 or 41, wherein an area of a projection of the second-charge-carrier selectively-collecting layer on the shadow face of the silicon substrate accounts for 5% to 45% of a total area of the shadow face of the silicon substrate.

45. The back-contacting solar cell according to claim 5, wherein the back-contacting solar cell further comprises a tunneling isolating layer;
the tunneling isolating layer is located between the shadow face of the silicon substrate and a light facing face shared by the metal-chalcogen-compound layer and the second-charge-carrier selectively-collecting layer; and
a thickness of the tunneling isolating layer is 0.1nm-5nm, and the tunneling isolating layer is one or more layers.

46. The back-contacting solar cell according to claim 5 or 41, wherein a fifth transparent electrically conductive thin film and/or a fifth work-function regulating layer are provided between the second electrode and the second-charge-carrier selectively-collecting layer; and both of the fifth transparent electrically conductive thin film and/or the fifth work-function regulating layer are located within a projection region of the second-charge-carrier selectively-collecting layer; and/or
a first transparent electrically conductive thin film and/or a first work-function regulating layer are provided between the first electrode and the first-charge-carrier collecting end; and both of the first transparent electrically conductive thin film and/or the first work-function regulating layer are located within a projection region of the first-charge-carrier collecting end.

47. The back-contacting solar cell according to claim 46, wherein a thickness of the fifth work-function regulating layer is 0.1-2nm.

48. The back-contacting solar cell according to claim 46, wherein if the fifth transparent electrically conductive thin film is provided between the second electrode and the second-charge-carrier selectively-collecting layer, the second electrode is provided at a shadow face of the fifth transparent electrically conductive thin film in the form of grid lines; and/or
if the first transparent electrically conductive thin film is provided between the first electrode and the first-charge-carrier collecting end, the first electrode is provided at a shadow face of the first transparent electrically conductive thin film in the form of grid lines.

49. The back-contacting solar cell according to claim 5 or 41, wherein a top view of the second-charge-carrier selectively-collecting layer is a punctate pattern or a linear pattern.

50. The back-contacting solar cell according to claim 5, wherein a light facing face of the silicon substrate is provided with at least one of a passivation layer, a front-face field-effect layer, a front-face antireflective-thin-film layer, a scattering-structure layer and a light-focusing-structure layer; and/or
at the shadow faces of both of the metal-chalcogen-compound layer and the second-charge-carrier transferring region, a back-face antireflective film is provided within a region outside the first electrode and the second electrode.

51. A method for producing a back-contacting solar cell, wherein the method comprises:
providing a silicon substrate, wherein a shadow face of the silicon substrate is delimited into a first region and a second region;
depositing within at least the first region of the silicon substrate to obtain a metal-chalcogen-compound layer, wherein a region of the metal-chalcogen-compound layer that corresponds to the first region forms a first-charge-carrier collecting end;
correspondingly providing a first electrode on the first-charge-carrier collecting end; and
correspondingly providing a second electrode within a region that corresponds to the second region.

52. The method for producing a back-contacting solar cell according to claim 51, wherein before the step of depositing within at least the first region of the silicon substrate to obtain the metal-chalcogen-compound layer, the method further comprises:
doping the silicon substrate within the second region, to form a second-charge-carrier collecting end;
the step of depositing within at least the first region of the silicon substrate to obtain the metal-chalcogen-compound layer comprises:
depositing on the whole shadow face of the silicon substrate to obtain the metal-chalcogen-compound layer, wherein a region of the metal-chalcogen-compound layer that corresponds to the second region forms a second-charge-carrier transferring region; and
the step of correspondingly providing the second electrode within the region that corresponds to the second region comprises:
correspondingly providing the second electrode within the second-charge-carrier transferring region.

53. A back-contacting cell assembly, wherein the back-contacting cell assembly comprises: the back-contacting solar cell according to any one of claims 1 to 50.
